# EUROPÄISCHE PATENTANMELDUNG

(11) **EP 3 875 642 A1**
(43) Veröffentlichungstag der Anmeldung: **08.09.2021**
(21) Anmeldenummer: 20172981.1
(22) Anmeldetag: 05.05.2020
(51) Int. Cl.: C25D 21/18, C25D 21/22, C25C 3/00, C25D 21/14, C25D 21/20, C25D 3/38

(54) **VERFAHREN ZUM AUFBEREITEN EINES SPÜLWASSERS AUS DER LEITERPLATTEN- UND/ODER SUBSTRAT-HERSTELLUNG**

(30) Priorität: 04.03.2020 EP 20160862
(71) Anmelder: AT & S Austria Technologie & Systemtechnik Aktiengesellschaft, 8700 Leoben-Hinterberg (AT)
(72) Erfinder: Klocek, Jolanta, 8712 Niklasdorf (AT); Payerl, Claudia, 8020 Graz (AT); Frey, Gerhard, 8793 Trofaiach (AT); Schrei, Martin, 8382 Mogersdorf (AT); Redl, Alois, 8712 Niklasdorf (AT); Ebinger, Christoph, 70599 Stuttgart (DE); Herzog, René, 8045 Graz (AT); Zanker, Andreas, 8753 Fohnsdorf (AT); Mandl, Thomas, 8720 Knittelfeld (AT); Gross, Friedrich, 8700 Leoben (AT); Kern, Konstantin, 8700 Leoben (AT); Moitzi, Heinz, 8740 Zeltweg (AT)
(74) Vertreter: Dilg, Haeusler, Schindelmann Patentanwaltsgesellschaft mbH

(57) **Zusammenfassung**

Es wird ein Verfahren (300) beschrieben zum Aufbereiten eines aufzubereitenden Mediums (31) aus der Leiterplatten- und/oder Substrat-Herstellung (insbesondere einem Spülwasser und/oder Restwasser), wobei das aufzubereitende Medium (31) ein Metall aufweist. Das Verfahren weist auf: i) Beladen (321) eines Ionentauschers (320) mit dem aufzubereitenden Medium (31) derart, dass das Metall zumindest teilweise an dem Ionentaucher (320) verbleibt, und ii) Regenerieren (322) des Ionentauschers (320) mittels Strömens eines Regeneriermediums (325, 326) durch den Ionentauscher (320) derart, dass das Metall zumindest teilweise in dem Regeneriermedium (325, 326) gelöst wird und ein Regenerat (326) bereitgestellt wird. Hierbei ist das Regeneriermedium (325, 326) zumindest teilweise Verfahrens-intern erzeugt.

## Beschreibung

Die Erfindung betrifft ein Verfahren zum Aufbereiten eines aufzubereitenden Mediums aus der Leiterplatten- und/oder Substrat-Herstellung, insbesondere einem Spülwasser und/oder Restwasser. Weiterhin betrifft die Erfindung eine Vorrichtung, insbesondere eine Industrieanlage, zum Ausführen des Verfahrens. Ferner betrifft die Erfindung ein Verwenden eines Ionentauschers, um eine Mehrzahl von Abwässern aus der Leiterplatten- und/oder Substrat-Herstellung gemeinsam aufzubereiten. Außerdem betrifft die Erfindung eine Prozesskontrollvorrichtung zum Regulieren des Verfahrens und/oder der Vorrichtung. Weiterhin betrifft die Erfindung ein Computerprogramm-Produkt zum Steuern des Verfahrens und/oder der Vorrichtung und/oder der Prozesskontrollvorrichtung.

Die Erfindung kann sich somit auf das technische Gebiet der Leiterplattenund/oder Substrat-Herstellung beziehen. Insbesondere kann sich die Erfindung auf das technische Gebiet des Aufbereitens von Spülwasser bzw. Restwasser aus der Leiterplatten- und/oder Substrat-Herstellung beziehen. Weiter kann sich die Erfindung auf das technische Gebiet des Recycelns innerhalb der Leiterplattenund/oder Substrat-Herstellung beziehen.

Für die Erzeugung von Leiterplatten und/oder Substraten werden prinzipiell große Mengen an Metallen, insbesondere Schwermetallen (z.B. Kupfer, Nickel, Gold, Silber, Palladium, Zinn, Eisen) benötigt. Innerhalb des Herstellungsprozesses fallen daher aus den unterschiedlichen Prozessen Metall-haltige Rückstände bzw. Metall-haltige Medien (insbesondere Lösungen) an.

Die aufzubereitenden Metall (-salz)-haltigen Medien (bzw. zu reinigenden Abfallund Rückstandskonzentrate) stammen im Wesentlichen aus zwei unterschiedlichen Verarbeitungsprozessen bei der Leiterplatten- und/oder Substrat-Herstellung: i) dem Ätzprozess (z.B. Ätzen von Kupferfolien) und ii) dem Galvanikprozess (z.B. Galvanisieren mit Kupferschichten, Gewinnen von reinem Metall, etc.).

Zudem fallen aufzubereitende Metall (-salz)-haltige Medien während Spülprozessen, z.B. aus dem Ätzprozess und dem Galvanikprozess an. Die aufzubereitenden Metall (-salz)-haltigen Medien aus den Ätzprozessen und den Galvanikprozessen weisen vergleichsweise hohe Konzentrationen an Metall auf, während die Spülwässer nur geringe Konzentrationen an Metall, insbesondere Kupfer, enthalten.

Es sind zwar prinzipiell Methoden bekannt, Metall aus den beschriebenen Metall (-salz)-haltigen Medien bzw. den Spülwässern rückzugewinnen. Allerdings ist ein rückgewonnenes Metall für die Leiterplatten- und/oder Substrat-Herstellung nur in hochreiner Form (z.B. 99% bis 99,99%, insbesondere etwa 99,9% rein) von Interesse. Eine solche Rückgewinnung kann z.B. mittels einer Elektrolyse erfolgen. Die oben beschriebenen Metall (-salz)-haltigen Medien und Spülwässer sind hierfür allerdings denkbar ungeeignet, denn die Abscheidung von reinem Metall (z.B. Kupfer) ist durch die Zusammensetzung der Metall (-salz)-haltigen Medien behindert und/oder erschwert. So kann das Salz einer Säure aus dem Ätzprozess in der Rückgewinnung zur Entstehung gefährlicher Gase führen (z.B. Chlorgas im Fall von Salzsäure). Ferner stören Fremdmetalle wie Eisen erheblich eine qualitativ hochwertige Elektrolyse. Die Spülwässer enthalten lediglich eine äußerst geringe Metall-Konzentration, jedoch meist einen sehr hohen Säuregehalt, wodurch eine wirtschaftliche Rückgewinnung nicht implementierbar erscheint. Aus diesem Grund werden konventionell Abfallkonzentrate und Spülwässer aus der Leiterplatten- und/oder Substrat-Herstellung auf kostenintensive und wenig umweltfreundliche bzw. nachhaltige Weise entsorgt.

Es ist eine Aufgabe der vorliegenden Erfindung ein umweltfreundliches und nachhaltiges, aber zugleich auch Kosten-effizientes Aufbereiten eines Spülwassers aus der Leiterplatten- und/oder Substrat-Herstellung innerhalb eines Wertstoffkreislaufs (Prozess-internes, bevorzugt kontinuierliches, Recycling) zu ermöglichen.

Diese Aufgabe wird durch die Gegenstände gemäß den unabhängigen Patentansprüchen gelöst. Bevorzugte Ausgestaltungen ergeben sich aus den abhängigen Patentansprüchen.

Gemäß einem Aspekt der vorliegenden Erfindung ist ein Verfahren beschrieben zum Aufbereiten eines aufzubereitenden Mediums (insbesondere einem Spülwasser und/oder Restwasser) aus der Leiterplatten- und/oder Substrat-Herstellung. Das aufzubereitende Medium weist hierbei zumindest ein Metall (insbesondere ein Metallsalz) auf. Das Verfahren weist auf: i) Beladen eines Ionentauschers mit dem aufzubereitenden Medium derart, dass das Metall (bzw. Metall-Ion) zumindest teilweise an dem Ionentaucher verbleibt (bzw. adsorbiert), und ii) Regenerieren des Ionentauschers mittels Strömens eines Regeneriermediums (insbesondere einer Regeneriersäure wie z.B. Schwefelsäure) durch den Ionentauscher derart, dass das Metall (bzw. Metall-Ion) (zumindest teilweise) in dem Regeneriermedium gelöst wird (und von dem Ionentauscher desorbiert wird) und ein (saures) Regenerat bereitgestellt wird. Hierbei ist das Regeneriermedium (zumindest teilweise, insbesondere im Wesentlichen) Verfahrens-intern erzeugt (z.B. dadurch, dass das Regeneriermedium mehrfach innerhalb eines Kreislaufs durch den Ionentauscher geführt wird und/oder dass großvolumige Säureabfälle (z.B. Elektrolyt) aus der Galvanik in die Spülwasser Aufbereitung umgeleitet werden).

Gemäß einem weiteren Aspekt der vorliegenden Erfindung ist eine Vorrichtung zum Aufbereiten eines aufzubereitenden Mediums (insbesondere einem Spülwasser und/oder Restwasser) aus der Leiterplatten- und/oder Substrat-Herstellung beschrieben, wobei das aufzubereitende Medium ein Metall aufweist. Die Vorrichtung aufweisend: ein Ionentauscher-Modul mit einem Ionentauscher zum i) Beladen mit dem aufzubereitenden Medium derart, dass das Metall an dem Ionentaucher verbleibt, und ii) Regenerieren des Ionentauschers mittels Strömens eines Regeneriermediums durch den Ionentauscher derart, dass das Metall zumindest teilweise in dem Regeneriermedium gelöst wird und ein Regenerat bereitgestellt wird. Hierbei ist das Regeneriermedium (zumindest teilweise) Vorrichtungs-intern (z.B. innerhalb des Ionentauscher-Moduls) erzeugt.

Gemäß einem weiteren Aspekt der vorliegenden Erfindung ist ein Verwenden eines Ionentauschers beschrieben, um eine Mehrzahl von Abwässern (z.B. aus einem Ätzprozess und/oder einem Galvanikprozess, insbesondere aus drei oder mehr Abtrennströmen) aus der Leiterplatten- und/oder Substrat-Herstellung derart gemeinsam aufzubereiten, dass ein (im Wesentlichen) Schwermetall-freies (insbesondere im Wesentlichen Säure-freies) Abwasser bereitgestellt ist, welches Einleitqualität aufweist.

Gemäß einem weiteren Aspekt der vorliegenden Erfindung wird eine Prozesskontrollvorrichtung zum Regulieren des oben beschriebenen Verfahrens und/oder der oben beschriebenen Vorrichtung diskutiert. Die Prozesskontrollvorrichtung weist auf: i) eine Datenbank zum Erfassen von zumindest einem Prozessparameter (bzw. einem Ist-Wert), insbesondere einer Mehrzahl von Prozessparametern, aus dem laufenden Prozess, ii) eine Datenmodell-Einheit, welche eingerichtet ist zum Speichern von zumindest einem vorbestimmten Prozessparameter (bzw. einem Soll-Wert), insbesondere einer Mehrzahl von vorbestimmten Prozessparametern, und iii) eine Berechnungsvorrichtung, welche eingerichtet ist zum a) Vergleichen des erfassten Prozessparameters mit dem vorbestimmten Prozessparameter (bzw. der Mehrzahlen miteinander), b) Bestimmen einer Steueroperation, welche auf dem Ergebnis des Vergleichens basiert (beispielsweise aktives Ausgleichen einer Differenz zwischen "Ist"-Wert und "Soll"-Wert), und c) Durchführen der bestimmten Steueroperation (z.B. Flussrate anpassen, etc...).

Gemäß einem weiteren Aspekt der vorliegenden Erfindung wird ein Computerprogramm-Produkt beschrieben zum Steuern eines Verfahrens zum Aufbereiten eines aufzubereitenden Mediums aus der Leiterplatten und/oder Substrat Herstellung, welches Computerprogramm-Produkt, wenn es von einem oder mehreren Prozessoren (bzw. einem oder mehreren Computern) ausgeführt wird, das Verfahren (wie oben beschrieben) und/oder die Vorrichtung (wie oben beschrieben) und/oder die Prozesskontrollvorrichtung (wie oben beschrieben) steuert.

Im Rahmen dieses Dokuments kann unter dem Begriff "Metallsalz-haltiges Medium" insbesondere jegliches (flüssige) Medium verstanden werden, welches ein Metallsalz aufweist. Ein Metallsalz ist eine chemische Verbindung zwischen einem Metall und einer Säure. Beispiele für ein solches Metall können umfassen: Kupfer, Nickel, Gold, Silber, Cobalt, Cadmium, Magnesium, Natrium, Palladium, Zinn. Beispiele für Säuren können umfassen: Schwefelsäure, Salzsäure, Salpetersäure, Phosphorsäure; wobei das Metallsalz entsprechend z.B. als Sulfat, Chlorid, Nitrat, oder Phosphat vorliegt. Entsprechend kann ein Metallsalz z.B. Kupfersulfat oder Kupferchlorid sein. Dieses kann in dem Metallsalz-haltigen Medium als Metall-Ion und Salz-Ion vorliegen. Ein Metallsalz-haltiges Medium kann neben Metallsalz eine Lösung aufweisen, welche z.B. wässrig oder sauer sein kann, in welcher das Metallsalz gelöst ist. Beispielsweise kann das Medium neben Wasser auch Salzsäure und/oder Schwefelsäure aufweisen. In einem Beispiel stammt das Metallsalz-haltige Medium aus der Herstellung von Leiterplatten und/oder Substraten und kann entsprechende Rückstände aufweisen. Ferner kann das Metallsalz-haltige Medium aufbereitet sein, so dass im Wesentlichen nur das Metallsalz vorliegt. In einem bevorzugten Beispiel ist das Metallsalz-haltige Medium (im Wesentlichen) frei von (unerwünschtem) Fremdmetall (wie z.B. Eisen).

Im Rahmen dieses Dokuments kann unter dem Begriff "aufzubereitendes Medium" insbesondere ein Medium aus der Leiterplatten- und/oder Substrat-Herstellung verstanden werden, welches mittels eines Aufbereitungsprozesses aufbereitet werden soll, weil es in der vorliegenden Zusammensetzung für einen bestimmten (durchzuführenden) Prozess nicht zweckdienlich eingesetzt werden kann. Ein aufzubereitendes Medium kann z.B. ein Spülwasser und/oder ein Restwasser sein. Dieses kann in einem Beispiel nicht zweckdienlich als Metall-Rohstoffquelle eingesetzt werden, weil die Konzentrationen zu gering und die Verschmutzungen zu hoch sind. Das aufzubereitende Medium kann durch Mischen einer Vielzahl von Spülwässern des Leiterplatten Herstellungsprozesses erhalten sein. Beispielsweise können Spülwässer aus verschiedenen Prozessschritten stammen wie Ätzprozess (als Diffusat), Galvanik (als Rückstand der Elektrolyse) oder aus einem Prozess zur Rückgewinnung von Metallen. Hierbei können die Spülwässer über Abtrennströme einem einzigen Aufbereitungsprozess zugeführt werden. Das aufzubereitende Medium kann ein saures (insbesondere stark saures) Medium sein. Ferner kann das aufzubereitende Medium eine (geringe) Konzentration an Metallsalz aufweisen. Insbesondere kann das Metallsalz während eines Aufbereitens vorteilhaft aufkonzentriert werden.

Im Rahmen dieses Dokuments kann unter dem Begriff "Ionentauscher" insbesondere Materialien (bzw. Vorrichtungen) umfassen, mit denen gelöste Ionen durch andere Ionen gleicher Ladung (positiv oder negativ) ersetzt werden können. Ionentauscher können z.B. als Säulen, die mit einem Ionenaustauschmaterial gefüllt sind, oder als Membranen realisiert werden, welche mit einer Lösung durchströmt werden. Die auszutauschenden Ionen werden am Ionenaustauschmaterial gebunden bzw. adsorbiert. In einem Beispiel weist ein Ionentauscher ein selektives Ionenaustauschharz, weiter insbesondere ein doppel-funktionalisiertes Ionenaustauschharz, auf.

In einem Ausführungsbeispiel weist das Trägermaterial des Ionenaustauschharzes des Ionentauscher Polystyrol auf. Dieses weist insbesondere zwei funktionelle Gruppen (doppel-funktionalisiertes Ionenaustauschharz) auf, z.B. i) einen Phosphonsäure-Rest und ii) einen Sulfonsäure-Rest. Die erste Säuregruppe weist dabei einen höheren pKs Wert auf als die zweite Säuregruppe. Die Säure mit dem höheren pKs Wert ist dabei die schwächere Säure und unterzieht sich schwerer einer Protolyse als die Säure mit dem niedrigerem pKs Wert (starke Säure). Dadurch kann während der Regeneration das Fremdmetall leichter vom Harz desorbiert werden.

In einem Ausführungsbeispiel hat es sich überraschend herausgestellt, dass gerade das Verwenden eines speziellen Ionenaustauschharzes mit zwei funktionellen Gruppen eine (effiziente) Desorption des Metalls (insbesondere Fe³⁺) ermöglicht. Dies ist insbesondere deswegen beachtenswert, weil Ionenaustauschharze (insbesondere einfach-funktionalisierte) teilweise zu einer irreversiblen Adsorption des Metalls neigen. Im Falle von Fe³⁺ wurde generell ein irreversibles Adsorbieren beobachtet.

In einem exemplarischen Beispiel ist der Ionenaustauscher zweistufig aufgebaut. Der nachgeschaltete (zweite) Ionenaustauscher nimmt den Metallrest des vorangeschalteten (zu beladenden) Ionenaustauschers auf. Weist der erste Ionentauscher einen erhöhten Metallrest auf, kann dieser regeneriert und anschließend an die nachgeschaltete (zweite) Stelle geschaltet werden.

Im Rahmen dieses Dokuments kann unter dem Begriff "Regenerieren" insbesondere verstanden werden, dass ein (selektiver) Ionentauscher von einem ersten Betriebszustand in einen zweiten Betriebszustand überführt wird. Insbesondere ist in dem ersten Betriebszustand ein Metall (insbesondere ein Kation) an dem Ionentauscher (bzw. Ionentauschharz) adsorbiert. Weiter insbesondere ist in dem zweiten Betriebszustand das Metall im Wesentlichen desorbiert. In diesem zweiten Betriebszustand kann der Ionentauscher also wieder betriebsbereit sein, um Beladen zu werden und entsprechend wieder den ersten Betriebszustand einzunehmen. Ein Regenerieren kann vorteilhaft vielfach wiederholt werden. In einem Beispiel wird das Regenerieren mittels eines Regeneriermediums durchgeführt, insbesondere einer Regeneriersäure wie Schwefelsäure und/oder Salzsäure. Bei einem Regenerieren kann das Regeneriermedium adsorbiertes Metall desorbieren. Nach einem Aufreinigen kann das Regeneriermedium erneut verwendet werden. In einem weiteren Beispiel muss das Regeneriermedium nicht aufgereinigt werden, so dass sich die Metallkonzentration in dem Regeneriermedium mit jedem (Regenerier-) Durchlauf durch den Ionentauscher weiter erhöht. Auf diese Weise kann ein "Regenerieren" in diesem Dokument auch ein Aufkonzentrieren eines rückzugewinnenden Metalls sein.

In anderen Worten, gemäß einem Ausführungsbeispiel, nimmt die Metallkonzentration zu, während die Säurekonzentration abnimmt. Die Regeneriersäure, welche bereits desorbierte Metall-Ionen enthält, wird solange wiederverwendet, bis die erhaltene Säurekonzentration zu gering ist, um die Metallionen vom Harz zu lösen. Die Säurekonzentration nimmt dann ab, denn kontinuierlich verbleiben Protonen (H⁺) der Säure am Harz.

Im Rahmen dieses Dokuments kann unter dem Begriff "Leiterplatten- und/oder Substrat-Herstellung" insbesondere ein Prozess verstanden werden zum Herstellen von Leiterplatten und/oder Substraten, welcher in einer Industrieanlage, beispielsweise einer Leiterplattenfabrik, durchgeführt wird. Der Begriff "Leiterplatten" kann sich insbesondere auf Leiterplatten (printed circuit board (PCB)) beziehen, während sich der Begriff "Substrate" z.B. auf Substrate für Halbleiter-Chips wie integrierte Schaltkreise oder organische Interposer beziehen kann. Eine Leiterplatten- und/oder Substrat-Herstellung umfasst gewöhnlich einen Ätzprozess, in welchem Metall mittels Ätzens derart entfernt wird, dass erwünschte Metallstrukturen erhalten werden, und einen Galvanisierungsprozess, in welchem Metall mittels Galvanisierens (plating) aufgetragen wird. Ausgangsmaterial für eine Leiterplatten- und/oder Substrat-Herstellung umfasst im Wesentlichen das Metall sowie elektrisch isolierendes Material, meist ein organisches Material wie ein Harz. Das Produkt des Prozesses kann die fertige Leiterplatte bzw. das Substrat sein, oder auch ein Zwischenprodukt.

Im Rahmen dieses Dokuments kann unter dem Begriff "Verfahrens-intern erzeugt" insbesondere verstanden werden, dass ein Medium (z.B. ein Regeneriermedium wie Regeneriersäure), welches in einem Verfahren eingesetzt wird, (im Wesentlichen) innerhalb desselben Verfahrens erzeugt (produziert) worden ist. Beispielsweise kann das Regeneriermedium mehrfach innerhalb eines Kreislaufs durch den Ionentauscher geführt werden (immer wieder recycelt, bzw. bis die Säurekonzentration zu niedrig ist, um einen Austausch des Metall-Ions mit einem Proton der Säure zu gewährleisten), so dass das eingesetzte Regeneriermedium innerhalb des Verfahrens der Spülwasser Aufbereitung erzeugt ist. In einem anderen Beispiel kann das Verfahren nicht nur die Spülwasser Aufbereitung umfassen, sondern auch weitere Prozesse der Leiterplatten- und/oder Substrat-Herstellung (bevorzugt innerhalb derselben Industrieanlage). In diesem Beispiel können auch großvolumige Säureabfälle (z.B. Elektrolyt aus der Galvanisierung bzw. Rückgewinnen von Metall) als Regeneriermedien in die Spülwasser Aufbereitung umgeleitet werden, wobei diese ebenfalls Verfahrens-intern erzeugt sind. Zugekaufte oder außerhalb einund derselben Leiterplatten/Substrat-Herstellung (z.B. innerhalb einer Industrieanlage) erzeugte Medien können hierbei als "Verfahren-extern erzeugt" bezeichnet werden.

Im Rahmen dieses Dokuments kann unter dem Begriff "Prozesskontrollvorrichtung" insbesondere jegliche Vorrichtung (oder Mehrzahl an Vorrichtungen) verstanden werden, welche geeignet ist eine Prozesskontrolle vorzunehmen, wobei der Prozess (zumindest teilweise) eine Leiterplatten- und/oder Substrat-Herstellung betrifft. Insbesondere ist die Prozesskontrollvorrichtung eingerichtet (zumindest teilweise) einen Wertstoffkreislauf zu steuern bzw. zu regeln, bei welchem Rückstände der Produktion derart rückgeführt werden, dass im Wesentlichen keine (Schwermetall und/oder Säure) Abfälle anfallen. Die Prozesskontrollvorrichtung kann hierfür insbesondere eine Datenbank (-Einheit) und eine Datenmodell-Einheit aufweisen, wobei erstere ermittelte Prozessdaten speichert, während letztere vorgesehene erwünschte Prozessdaten speichert. Die Prozesskontrollvorrichtung kann mit einer Vielzahl von Sensoren bzw. Messgeräten gekoppelt sein, um auf diese Weise an verschiedenen Prozessstationen aktuelle Parameter zu bestimmen. Ferner kann die Prozesskontrollvorrichtung eine Berechnungsvorrichtung aufweisen, welche die ermittelten Parameter mit den erwünschten vergleicht und basierend hierauf eine Steueroperation bestimmt und durchführt. In einem bevorzugten Ausführungsbeispiel weist die Prozesskontrollvorrichtung einen selbstlernenden Algorithmus (AI) auf, mittels welchem das Steuern bzw. das Regeln des Prozesses stetig verbessert werden kann.

Im Kontext des vorliegenden Dokuments kann der Begriff "(gedruckte) Leiterplatte" (PCB) insbesondere einen im Wesentlichen plattenförmigen Komponententräger (dieser kann flexibel, rigide, oder semi-flexibel sein) bezeichnen, welcher gebildet wird, indem mehrere elektrisch leitfähige Schichtstrukturen mit mehreren elektrisch isolierenden Schichtstrukturen laminiert werden, beispielsweise indem Druck angelegt wird und/oder indem thermische Energie zugeführt wird. Als bevorzugte Materialien für die PCB Technologie sind die elektrisch leitfähigen Schichtstrukturen aus Kupfer, wohingegen die elektrisch isolierenden Schichtstrukturen Harz und/oder Glasfasern aufweisen können, sogenanntes Prepreg oder FR4 Material. Die verschiedenen elektrisch leitfähigen Schichtstrukturen können miteinander auf gewünschte Weise verbunden werden, indem Durchgangsöffnungen durch das Laminat gebildet werden, beispielsweise mittels Laserbohrens oder mechanischen Bohrens, und indem diese mit elektrisch leitfähigem Material (insbesondere Kupfer) gefüllt werden, wobei dadurch Vias als Durchgangsöffnung Verbindungen gebildet werden. Neben einer oder mehreren Komponenten, welche in eine gedruckte Leiterplatte eingebettet sein können, ist eine gedruckte Leiterplatte typischerweise konfiguriert zum Aufnehmen von einer oder mehreren Komponenten auf einer oder beiden entgegengesetzten Oberflächen der plattenförmigen gedruckten Leiterplatte. Sie können mit der entsprechenden Hauptoberfläche mittels Lötens verbunden werden. Auch können diese Komponenten eingebettet werden. Ein dielektrischer Teil einer PCB kann Harz mit verstärkenden Strukturen (beispielsweise Glasfasern oder Glaskugeln) umfassen.

Im Kontext des vorliegenden Dokuments kann der Begriff "Substrat" insbesondere einen kleinen Komponententräger bezeichnen, welcher im Wesentlichen dieselbe Größe wie eine Komponente hat (insbesondere einer elektronischen Komponente), welche darauf zu montieren ist (wie bei einem Chip Scale Package (CSP)). Insbesondere kann unter einem Substrat ein Träger für elektrische Verbindungen oder elektrische Netzwerke oder auch ein Komponententräger verstanden werden, welcher mit einer gedruckten Leiterplatte (PCB) vergleichbar ist, allerdings mit einer beträchtlich höheren Dichte von seitlich und/oder vertikal angeordneten Verbindungen. Seitliche Verbindungen sind beispielsweise leitfähige Pfade, wohingegen vertikale Verbindungen beispielsweise Bohrlöcher sein können. Diese seitlichen und/oder vertikalen Verbindungen sind in dem Substrat angeordnet und können verwendet werden, um elektrische und/oder mechanische Verbindungen von gehäusten Komponenten oder ungehäusten Komponenten (beispielsweise Dies) bereitzustellen, insbesondere von IC Chips mit einer gedruckten Leiterplatte oder einer Zwischen-gedruckten Leiterplatte. Somit enthält der Begriff "Substrat" auch "IC Substrate". Ein dielektrischer Teil eines Substrats kann Harz mit verstärkenden Partikeln (beispielsweise verstärkende Kugeln, insbesondere Glaskugeln) umfassen.

Das Substrat oder der Interposer kann aus zumindest einer Glas-Schicht (Silizium (Si)) oder einer fotostrukturierbaren, oder einer trockenätzbaren organischen Schicht bestehen. Als organisches Material/organische Schicht kann beispielsweise ein Epoxid-basiertes Aufbaumaterial (beispielsweise Epoxidbasierter Aufbaufolie) oder Polymerverbindungen wie Polyimid, Polybenzoxazol oder Benzocyclobuten-funktionalisierten Polymeren herangezogen werden.

In einer Ausführungsform ist der Komponententräger ein Laminat-Typ Komponententräger. In einer derartigen Ausführungsform ist der Komponententräger ein Verbund aus mehreren Schichtstrukturen, welche gestapelt sind und miteinander verbunden sind, indem eine Presskraft und/oder Wärme aufgebracht wird.

In einer Ausführungsform weist zumindest eine der elektrisch leitfähigen Schichtstrukturen zumindest eines aus der Gruppe auf bestehend aus Kupfer, Aluminium, Nickel, Silber, Gold, Palladium, Magnesium, und Wolfram. Obwohl Kupfer typischerweise bevorzugt ist, sind auch andere Materialien oder beschichtete Versionen davon möglich, insbesondere beschichtet mit einem supra-leitfähigen Material wie beispielsweise Graphen.

In diesem Dokument kann unter dem Begriff "Schwermetall" insbesondere ein Metall verstanden werden, welches eine Dichte größer als 5,0 g/cm³ (alternativ größer als 4,5 g/cm³) aufweist. Hierzu zählen z.B. Kupfer, Nickel, Cobalt, Gold, Silber, Palladium, Wolfram, Zinn, Zink, Eisen, Blei, Chrom, Rhodium, Cadmium, etc. Nicht als Schwermetall bezeichnet werden nach dieser Definition z.B. Aluminium, Silizium, Natrium, Kalium, Calcium, Magnesium, etc.

In diesem Dokument kann unter dem Begriff "Ätzprozess" insbesondere ein Prozess der Leiterplatten- und/oder Substrat-Herstellung bezeichnet werden, welcher das Ätzen von Metall, insbesondere Kupfer, aufweist, um dadurch eine erwünschte metallische (elektrisch leitfähige) Struktur bereitzustellen. Gemäß einem exemplarischen Ausführungsbeispiel kann dieser Prozess wie folgt durchgeführt werden: ein Fotolack schützt Kupferpfade, die nicht weggeätzt werden sollen, während Kupferflächen, welche weggeätzt werden sollen, nicht mit dem Fotolack bedeckt sind. Zunächst wird hierzu die gesamte Kupferlage mit Fotolack überzogen. Dann wird durch eine Maske hinweg der Fotolack mittels UV-Licht entwickelt. Die Maske lässt nur an Stellen UV-Licht durch, an welchen der Fotolack bestehen bleiben soll (i.e. wo die erwünschten Leiterzüge bereitgestellt werden sollen). Während des Entwickelns vernetzt der Lack (bzw. das Polymer) an diesen Stellen, die mit UV-Licht belichtet wurden. Nach dem Entwickeln kann der Fotolack, welcher nicht belichtet wurde (bzw. nicht entwickelt wurde) einfach herunter gewaschen werden. Anschließend wird das Panel (bzw. die Komponententräger Vorform) geätzt. Der Fotolack schützt dabei die Leiterzüge während das Kupfer, das nicht mit Fotolack bedeckt ist, geätzt/entfernt wird. Wenn der Ätzvorgang vorüber ist, wird der Fotolack entfernt bzw. abgezogen (der Lack ist vernetzt und fest) und die Leiterbahnen bleiben übrig. Der gestrippte Fotolack kann zu einem späteren Zeitpunkt mittels Eisenchlorid gefällt werden.

Gemäß einem exemplarischen Ausführungsbeispiel kann die Erfindung auf der Idee basieren, dass ein Kosten-effizientes (bzw. wirtschaftliches), umweltfreundliches und nachhaltiges Aufbereiten eines Spülwassers (insbesondere einer Mischung einer Mehrzahl von Spülwässern) der Leiterplatten- und/oder Substrat-Herstellung innerhalb eines Wertstoffkreislaufs ermöglicht ist, wenn das Spülwasser mittels eines Ionentauschers von Schwermetall gereinigt wird, wobei aber das Regeneriermedium des Ionentauschers aus dem Prozess selbst stammt. Auf diese Weise ist es z.B. ermöglicht, (im Wesentlichen) ein und dasselbe Regeneriermedium immer wieder durch den Ionentauscher laufen zu lassen, um ein (selektives) Aufkonzentrieren des Schwermetalls in dem Regeneriermedium zu erreichen. Daraus ergeben sich gleich zwei besondere Vorteile: i) das Spülwasser kann derart aufgereinigt werden, dass ein (im Wesentlichen) Schwermetall- und Säure-freies Medium in Einleitqualität den Prozess verlässt, während ii) durch den Prozess des Schwermetall-Abtrennens ein- und dasselbe Regeneriermedium immer weiter (selektiv) an Schwermetall aufkonzentriert wird, wodurch ein derart (hoch-) konzentriertes (Metallsalz-haltiges) Medium erhalten wird, dass ein wirtschaftliches Rückgewinnen des Metalls (z.B. mittels Elektrolyse) ermöglicht ist. Alle diese Schritte können innerhalb ein- und desselben Leiterplattenund/oder Substrat-Herstellungsprozesses durchgeführt werden (und somit einen geschlossenen Wertstoffkreislauf bereitstellen). Im Vergleich zu konventionellen Regeneriertechniken fällt zudem nur wenig flüssiges Medium an und es muss im Prinzip kein Wasser mehr aus dem Regenerat entfernt werden.

Konventionell werden Abfallkonzentrate und Spülwässer aus der Leiterplattenund/oder Substrat-Herstellung auf kostenintensive und wenig umweltfreundliche bzw. nachhaltige Weise entsorgt. Dies auch deswegen, weil Spülwässer nur äußerst geringe Konzentrationen an (rückzugewinnenden) Metallen aufweisen und zudem durch eine hohe Konzentration an Säure und (organischen) Abfallstoffen prädestiniert dafür sind, als Sondermüll aufwendig entsorgt zu werden. Eine (zwingend notwendige) qualitativ hochwertige Rückgewinnung (z.B. mittels Elektrolyse) erscheint nicht auf Kosten-effiziente Weise ermöglicht.

Es wurde nun aber überraschend erkannt, dass gerade diese Spülwässer besonders vorteilhaft innerhalb einer Industrieanlage zur Leiterplatten- und/oder Substrat-Herstellung aufbereitet werden können. Die Spülwasser Aufbereitung kann z.B. direkt innerhalb einer Produktionsanlage mit einer Vielzahl von Abwässern verschaltet werden und Abtrennströme aus den verschiedenen Prozessschritten können innerhalb dieser Spülwasser Aufbereitung derart aufbereitet werden, dass als Abfluss lediglich ein Medium in Einleit-Qualität anfällt, während ein aufkonzentriertes Regeneriermedium als Rohstoffquelle für ein Rückgewinnen der benötigten Prozessausgangsmaterialien umfunktioniert werden kann. Entsprechend können diese Prozessausgangsmaterialien wieder zurück an die verschiedenen Prozessschritte geleitet werden.

Hierbei kann das Regeneriermedium direkt aus einem oder mehr Abtrennströmen des Herstellungsprozesses stammen. Beispielsweise kann das Regeneriermedium im Wesentlichen Säure(n) aus einem oder mehr Prozessschritten der Leiterplatten- und/oder Substrat-Herstellung aufweisen.

Während aufzubereitende Medien wie Spülwässer (bzw. Restwässer) aus der Leiterplatten- und/oder Substrat-Herstellung also bislang aufgrund der geringen Konzentration an Metall und hohen Konzentration an Säure (und organischen Abfällen) als aufwendig zu entsorgendes Abfallprodukt angesehen wurden, wird nun in völligem Gegensatz hierzu beschrieben, dass ein Kosten-effizientes Rückführen von Metall innerhalb ein- und desselben Produktionsprozesses ermöglicht ist.

Gemäß einem Ausführungsbeispiel weist das Regeneriermedium Schwefelsäure (H₂SO₄) auf. Insbesondere stammt die Schwefelsäure aus einem Prozess der Leiterplatten- und/oder Substrat-Herstellung, wie z.B. einem Galvanisierprozess und/oder einem Rückgewinnen mittels Elektrolyse). Dadurch kann ein relevantes Industrieprodukt, welches während der Produktion in besonders hohen Volumina anfallen kann, besonders vorteilhaft (Prozess-intern) recycelt werden.

Während einer Elektrolyse (im Rahmen einer Leiterplatten- und/oder Substratherstellung, z.B. bei einem Galvanisieren von Leiterplatten oder einem Rückgewinnen von Metall) kann ein besonders großes Volumen an Schwefelsäure (z.B. 1000 L pro Tag) anfallen. Dadurch kann (im Wesentlichen) die gesamte Menge an produzierter Schwefelsäure als Regeneriersäure (bzw. Regeneriermedium) für das Aufbereiten von Spülwässern herangezogen werden. Dies kann den Vorteil bereitstellen, dass (im Wesentlichen) keine Schwefelsäure in den Wertstoffkreislauf zugeführt (bzw. zugekauft) werden muss.

In einem Ausführungsbeispiel wird vorliegendes Metall mittels eines selektiven Ionenaustauschharzes von den Abfallkonzentraten getrennt. Das am Harz immobilisierte Metall wird anschließend über eine spezielle Regeneriertechnik gelöst. Während konventionelle Harze mittels Salzsäure bei einem maximalen Gehalt von 1,5 bis 8 Gewichtsprozent regeneriert werden, haben die Erfinder überraschend festgestellt, dass die Regeneration auch mit stark konzentrierten Säuren effizient durchführbar ist. Daher kann das Metall (z.B. Kupfer) mittels konzentrierter Schwefelsäure effizient vom Harz gelöst werden, mit dem Effekt diese Säure mehrfach verwenden zu können.

Gemäß einem weiteren Ausführungsbeispiel weist das Regeneriermedium eine hohe Säurekonzentration aufweist, insbesondere ≥ 200 g/L, weiter insbesondere ≥ 300 g/L, weiter insbesondere ≥ 400 g/L, weiter insbesondere ≥ 500 g/L (z.B. an Schwefelsäure). Dies kann den Vorteil haben, dass ein überraschend effizientes Recycling trotz des sehr hohen Säureanteils ermöglicht ist. Insbesondere kann das stark saure Regeneriermedium wiederum verwendet werden, um im Prozess (bzw. in verschiedenen Prozessschritten wie Säuredialyse oder Ätzprozess) benötigte Säure rückzugewinnen (anstatt neue hinzuzufügen).

Gemäß einem weiteren Ausführungsbeispiel weist das Metall zumindest ein Metall aus der Gruppe auf, welche besteht aus: Kupfer, Nickel, Cobalt, Palladium, Rhodium, Zinn, Cadmium, Magnesium, Natrium, Eisen, Gold, Silber. Dies hat den Vorteil, dass elementare Ausgangsstoffe der Leiterplatten- und/oder Substratherstellung auf effiziente Weise rückgewonnen werden können und entsprechend in einem (im Wesentlichen) geschlossenen Kreislauf verbleiben.

Gemäß einem weiteren Ausführungsbeispiel liegt das Metall als Metallsalz vor (insbesondere als Metallsulfat, weiter insbesondere als Kupfersulfat). Dies kann den Vorteil haben, dass ein Massenprodukt (Metallsulfat) der Galvanisierung (im Wesentlichen) vollständig recycelt bzw. innerhalb desselben Prozesses rückgeführt werden kann.

Gemäß einem weiteren Ausführungsbeispiel weist das Regenerieren ferner auf: Bereitstellen des Regenerats, welches zumindest einen Teil des Metalls aus dem aufzubereitenden Medium und zumindest einen Teil des Regeneriermediums (Säure) aufweist, für ein Verfahren-internes Bereitstellen von Regeneriermedium. Dies kann den Vorteil haben, dass das Regeneriermedium vor allem dadurch Verfahrens-intern erzeugt wird, dass Metall- (desorbiert von dem Ionentauscher) haltiges Regenerat nicht als Abfallprodukt angesehen wird, sondern direkt recycelt wird.

Gemäß einem weiteren Ausführungsbeispiel weist das Regenerieren ferner auf: Verwenden des Regenerats (zumindest teilweise) als weiteres Regeneriermedium für zumindest einen weiteren Regenerierschritt in dem Ionentauscher. Dies kann den Vorteil haben, dass Material gespart werden kann, während zugleich eine Aufkonzentrierung in dem Regenerat stattfindet und Abfall reduziert wird.

Gemäß einem weiteren Ausführungsbeispiel weist das Regenerieren ferner auf: Durchführen von zumindest drei (insbesondere zumindest fünf, weiter insbesondere zumindest acht) weiteren Regenerierschritten unter Verwenden des Regenerats. Insbesondere steigt die Konzentration des Metalls in dem Regenerat mit jedem Regenerierschritt an während die Säurekonzentration abnimmt. Dies kann ebenfalls den Vorteil haben, dass Material gespart werden kann, während zugleich eine Aufkonzentrierung in dem Regenerat stattfindet und Abfall eingespart wird.

Gemäß einem weiteren Ausführungsbeispiel weist die Vorrichtung ferner auf: ein Speicher-Modul i) zum Speichern des Regenerats aus dem Ionentauscher, wobei das Regenerat zumindest einen Teil des Metalls aus dem aufzubereitenden Medium und zumindest einen Teil des Regeneriermediums aufweist, und ii) zum Verwenden des Regenerats (zumindest teilweise) als weiteres Regeneriermedium für ein oder mehr weitere Regenerierschritte in dem Ionentauscher.

Gemäß einem weiteren Ausführungsbeispiel weist das Regenerieren ferner auf: Zuführen von weiterer Säure (insbesondere Schwefelsäure) zu dem Regeneriermedium (insbesondere zu dem Regenerat). Dies kann den Vorteil haben, dass die Regeneriersäure (insbesondere kontinuierlich) nachgeschärft werden kann, bzw. die Konzentration gezielt auf einen erwünschten Wert eingestellt werden kann. Zugleich können anfallende Abfälle aus weiteren Prozessschritten (Säureabfälle) hierbei effizient recycelt werden.

Gemäß einem exemplarischen Ausführungsbeispiel muss, damit das Metall von dem Harz desorbieren kann, das Harz geleichzeitig ein Proton (H⁺) von der Regeneriersäure aufnehmen. Die H⁺-Konzentration stellt hierbei die Säurekonzentration dar. Beim Regenerieren nimmt die Säurekonzentration ab, da kontinuierlich Protonen am Harz adsorbiert werden, während Metall-Ionen desorbiert werden. Daher wird mit einer hochkonzentrierten Säure gestartet, um dem Harz genügend Protonen für eine Mehrfachgeneration zur Verfügung stellen zu können. Somit findet eine Abnahme der Säurekonzentration statt, wodurch die Säure immer wieder mit Vorteil "nachgeschärft" wird.

Gemäß einem weiteren Ausführungsbeispiel ist die weitere Säure (im Wesentlichen) nicht innerhalb der Spülwasser Aufbereitung erzeugt. Dies kann Vorteil haben, dass weitere Abfälle aus der Leiterplatten- und/oder Substrat-Herstellung innerhalb der Spülwasser Aufbereitung recycelt werden können, während zeitgleich die Konzentration des Regeneriermedium durch das Zuleiten gezielt gesteuert werden kann.

Gemäß einem weiteren Ausführungsbeispiel ist die weitere Säure (im Wesentlichen) nicht Verfahren-intern erzeugt (bzw. nicht zum Recyceln rückgeführt ist). Dies kann den Vorteil haben, dass gezielt nachgeschärft werden kann und/oder eine bestimmte Konzentration besonders effizient eingestellt werden kann.

Gemäß einem weiteren Ausführungsbeispiel stammt die weitere Säure (im Wesentlichen) aus der Leiterplatten- und/oder Substrat-Herstellung. Dies insbesondere aus einem Prozess zum Rückgewinnen (z.B. mittels Elektrolyse). Dies kann den Vorteil haben, dass ein in besonders hohen Volumen anfallendes Medium aus der Leiterplatten- und/oder Substrat-Herstellung innerhalb der Spülwasser Aufbereitung recycelt und/oder aufgereinigt werden kann.

In einem Ausführungsbeispiel wird der Ionenaustauscher der Spülwässer (zumindest teilweise) mit verbrauchtem Elektrolyt (als Regeneriermedium), welcher nur noch eine geringe Konzentration an Metall aufweist, regeneriert. Während der Elektrolyse entsteht Schwefelsäure, welche vom Elektrolyt abgetrennt werden muss, um die gewünschte Abscheiderate erhalten zu können. Eine Möglichkeit ist das Betreiben der Elektrolyse nur so lange, bis der Elektrolyt eine definierte Säure- und Metall Konzentration (z.B. Cu²⁺ etwa 5 g/L) erreicht hat. Anschließend kann dieser verbrauchte Elektrolyt für die Regeneration des Ionenaustauschers zur Aufbereitung der Spülwässer herangezogen werden. Dadurch verbleibt das Metall im Wertstoffkreislauf und die Säure muss nicht über eine Dialyse in einem zusätzlichen Prozessschritt abgetrennt werden.

Gemäß einem weiteren Ausführungsbeispiel weist das Verfahren auf: Bereitstellen des aufzubereitenden Mediums mittels zumindest einem aus der Gruppe für die Leiterplatten- und/oder Substrat-Herstellung, welche besteht aus: i) einem Spülwasser und/oder einem Restwasser, ii) einem Diffusat aus einem Verfahren zum Aufbereiten von Rückständen aus einem Ätzprozess, bereitgestellt mittels eines ersten Abtrennstroms, iii) einem Diffusat aus einem Verfahren zum Aufbereiten von Rückständen aus einem Galvanikprozess, bereitgestellt mittels eines zweiten Abtrennstroms, iv) einem Diffusat aus einem Verfahren zum Rückgewinnen von aufbereiteten Rückständen, bereitgestellt mittels eines dritten Abtrennstroms. Dies kann den Vorteil bringen, dass die Spülwasser Aufbereitung mit einer Vielzahl verschiedener Prozessschritte gekoppelt werden kann und als effiziente (direkte und zentrale) Aufbereitungseinheit für Abtrennströme wirkt.

In einem Ausführungsbeispiel wird das aufzubereitende Medium bereitgestellt durch Mischen einer Vielzahl von Spülwässern des Herstellungsprozesses. Ein erstes Spülwasser kann ein Diffusat aus einem ersten Aufbereitungsprozess zum Aufbereiten von Rückständen aus dem Ätzprozessen sein, welches über den ersten Abtrennstrom bereitgestellt wird. Ein zweites Spülwasser kann ein Diffusat aus dem zweiten Aufbereitungsprozess zum Aufbereiten von Rückständen aus der Galvanik sein, welches über den zweiten Abtrennstrom bereitgestellt wird. Ein drittes Spülwasser kann ein Diffusat sein aus dem Rückgewinnen von elementarem Metall aus den aufbereiteten Rückständen, welches über den dritten Abtrennstrom bereitgestellt wird. Ferner können noch weitere Spülwässer aus dem Leiterplattenprozess (falls anfallend) bereitgestellt werden. Diese resultieren letztendlich aus dem Prozess zugeführtem Wasser. Die beschriebenen Abtrennströme können alle gemischt werden, teilweise gemischt werden, oder separat voneinander aufbereitet werden.

Gemäß einem weiteren Ausführungsbeispiel weist das Verfahren auf: Vorbehandeln des aufzubereitenden Mediums. Insbesondere weist das Vorbehandeln auf: Einstellen des pH-Werts des aufzubereitenden Mediums, insbesondere mittels Natronlauge, auf einen Wert im Bereich 1 bis 3 (insbesondere im Wesentlichen 2) und/oder chemisches Reduzieren des aufzubereitenden Mediums mittels eines Reduktionsmittels (z.B. Bisulfit). Dies kann den Vorteil haben, dass ein Spülwasser bzw. eine Mischung aus inhomogenen Spülwässern, zunächst derart vorbehandelt wird, dass ein effizientes und robustes weiteres Aufbereiten, insbesondere Regenerieren, ermöglicht ist.

Starke Oxidationsmittel wie Wasserstoffperoxid können ein Ionenaustauschharz angreifen. Insbesondere Wasserstoffperoxid kann sukzessive das Harz zersetzen. Das (gemischte) aufzubereitende Medium wird daher z.B. einer Vorbehandlung unterzogen, wenn sehr niedrige pH-Werte vorliegen (z.B. durch die starken Säuren in den Diffusaten). Ferner können starke Oxidationsmittel wie Wasserstoffperoxid vorliegen, welche mit Vorteil reduziert werden. Ferner kann das aufzubereitende Medium auch einen hohen Organik-Anteil aufweisen.

Zudem kann in einem exemplarischen Ausführungsbeispiel ein stark saurer pH-Wert dazu führen, dass die Aufnahmekapazität abnimmt, d.h. weniger Metalle adsorbieren können, weil gleichzeitig regeneriert wird. Das Harz nimmt zwar ein Metall-Ion auf, tauscht dieses aber sofort wieder gegen ein Proton der Säure. Daher kann der pH-Wert mit Vorteil vor dem Beladen angehoben werden.

In einem Ausführungsbeispiel wird das Medium (im Wesentlichen) dadurch Säure-frei, dass Spülwässer neutralisiert werden. Das passiert z.B. in einem vorgeschalteten Vorbehandlungsbecken, in welchem die Ströme gesammelt und der pH-Wert angehoben wird. In einem exemplarischen Beispiel wird der pH-Wert lediglich auf z.B. 3 oder 5 angehoben, um Lauge zur Neutralisation zu sparen. Diese Neutralisation hat zugleich den Vorteil, dass der Ionentauscher effizienter Metall aufnehmen kann, denn Protonen der Säure verdrängen das adsorbierte Metall. Ferner können in dem Vorbehandlungsbecken das Redoxpotential eingestellt (Reduzieren von H₂O₂) und organische Verbindungen (Aktivkohlefilter) entfernt werden.

In einem Ausführungsbeispiel wird der pH-Wert mittels einer Base eingestellt (neutralisiert). In einem weiteren Beispiel wird ein chemisches Reduzieren mittels eines Reduktionsmittels durchgeführt. Zusätzlich oder alternativ kann ein Aktivkohle-Filter vorgesehen werden. Dieser kann neben einem Separieren der Organik auch Wasserstoffperoxid zersetzen. Dies hat den Vorteil, dass zeitgleich und ohne weitere Aufwendungen organische Reste aus den Spülwässern entfernt werden können.

In einem Ausführungsbeispiel wird das beschriebene Vorbehandeln durchgeführt bevor das aufzubereitende Medium in den Ionentauscher geladen wird. In einem weiteren Ausführungsbeispiel wird das beschriebene Vorbehandeln als Nachbehandeln durchgeführt nachdem das aufzubereitende Medium den Ionentauscher verlassen hat (insbesondere wenn ein oxidationsbeständiges Harz verwendet wird).

Gemäß einem weiteren Ausführungsbeispiel weist das Verfahren (insbesondere das Vorbehandeln des aufzubereitenden Mediums) auf: Entfernen von organischen Rückständen. Gemäß einem weiteren Ausführungsbeispiel ist ein organischer Filter (insbesondere ein Aktivkohlefilter) an das Vorbehandlungsbecken gekoppelt, um organische Bestandteile zu filtern. Dies kann den Vorteil bereitstellen, dass ein erwünschter CSB-Wert (und eine entsprechende Einleitqualität) erreicht werden kann.

Gemäß einem weiteren Ausführungsbeispiel weist der Ionentauscher ein Oxidationsmittel-beständiges (insbesondere Wasserstoffperoxid-beständiges) Ionenaustauschharz auf. Dies kann den Vorteil haben, dass auf ein Reduzieren des aufzubereitenden Mediums verzichtet werden kann und/oder, dass der Ionentauscher besonders robust betrieben werden kann.

Gemäß einem weiteren Ausführungsbeispiel weist das Verfahren auf: Separieren eines Abwassers aus dem Ionentauscher, wobei das Abwasser (im Wesentlichen) Schwermetall-frei ist. Insbesondere liegt das Abwasser in Einleitqualität vor. Die Konzentration an Schwermetall kann 15 mg/L oder weniger betragen. Die Konzentration an Kupfer kann 0,5 mg/Loder weniger betragen. Ferner kann die Konzentration von Eisen 2 mg/L oder weniger betragen. Diese Werte liegen z.B. innerhalb der gesetzlichen Grenzwerte der Republik Österreich. Dies kann den Vorteil bereitstellen, dass als Abfallprodukt einer Leiterplatten- und/oder Substrat-Herstellung (im Wesentlichen) nur ein Medium in Einleitqualität anfällt, wodurch die Produktion umweltfreundlich und nachhaltig sein kann.

In einem Ausführungsbeispiel wird der Ionentauscher mit dem aufzubereitenden Medium derart beladen, dass das Metall, welches das aufzubereitende Medium aufweist, an dem Ionentaucher verbleibt. Dadurch strömt aus dem Ionentauscher ein Abwasser, welches (im Wesentlichen) Wasser, Salz (z.B. Magnesium-, Natrium-, Calcium-Salze), und Organik aufweist und (im Wesentlichen) Schwermetall-frei ist. Dieses Abwasser Medium weist daher eine Einleitqualität in Kläranlagen auf. Das Abwasser Medium kann auch eine Einleitqualität in Gewässer aufweisen.

Insbesondere wenn es derart aufgereinigt ist (z.B. in einer Prozess-internen Kläranlage und/oder mittels eines Aktivkohlefilters). Beispielsweise kann nach dem Aufreinigen der CSB (chemischer Sauerstoffbedarf)-Wert, als Maß für die Konzentration organischer Verbindungen, in dem Medium in Einleitqualität weniger als 300 mg/L, insbesondere weniger als 75 mg/L (weiter insbesondere weniger als 65 mg/L), betragen. Der CSB Wert kann hierbei die Menge an Sauerstoff (in mg/L) angeben, die zu der Oxidation der oxidierbaren Stoffe benötigt würde, wenn Sauerstoff das Oxidationsmittel wäre. Beispielsweise in Österreich liegt dieser Grenzwert per Gesetz bei 75 mg/L. Der CSB-Grenzwert für Kläranlagen kann stark variieren, und beträgt in einem Beispiel 300 mg/L.

Gemäß einem weiteren Ausführungsbeispiel weist das Verfahren weiter auf: Bereitstellen eines Metallsalz-haltigen Mediums aus dem Regenerat (an weitere Prozessschritte). Dies kann den Vorteil haben, dass ein (hoch) konzentriertes Medium einem Rückgewinnen zugeführt werden kann, wodurch sich der Prozess noch effizienter gestalten lässt.

Gemäß einem weiteren Ausführungsbeispiel weist das Verfahren weiter auf: Rückgewinnen von elementarem Metall aus dem Metallsalz-haltigen Medium in einer Reaktionszelle (insbesondere mittels Elektrolyse). Das elementare Metall (z.B. Kupfer) des Metallsalz-haltigen Mediums soll in der Reaktionszelle in (hoch) reiner Form rückgewonnen werden, um einem/dem Prozess zum Herstellen von Leiterplatten und/oder Substraten erneut zugeführt zu werden. Insbesondere wird das erhaltene elementare Metall in einen/den Galvanisierungsprozess rückgeführt.

Gemäß einem weiteren Ausführungsbeispiel wird das Aufbereiten kontinuierlich betrieben. Dies kann den Vorteil haben, dass ein kontinuierliches Aufkonzentrieren des aufzubereitenden Mediums stattfindet bzw. dass der Ionentauscher besonders effizient regeneriert werden kann.

Gemäß einem weiteren Ausführungsbeispiel weist die Berechnungsvorrichtung einen selbstlernenden Algorithmus (insbesondere mittels neuronaler Netzwerke) auf zum Vergleichen und/oder zum Bestimmen. Dies kann den Vorteil bereitstellen, dass die Prozesskontrollvorrichtung (zumindest teilweise) selbstständig arbeiten und sich basierend hierauf weiterentwickeln kann. Ein selbstlernender Algorithmus (maschinelles Lernen) kann ein künstliches System sein, welches aus Beispielen (bzw. Anwendungen) lernt und diese (nach oder während einer Lernphase) verallgemeinert. Ein solcher Algorithmus kann z.B. mittels neuronaler Netzwerke realisiert werden.

Gemäß einem weiteren Ausführungsbeispiel i) ist der selbstlernende Algorithmus eingerichtet, die bestimmte Steueroperation automatisch durchzuführen, und/oder ii) der selbstlernende Algorithmus ist eingerichtet die bestimmte Steueroperation einem Benutzer zum Überprüfen bereitzustellen. Dadurch kann sich der Vorteil ergeben, dass der selbstlernende Algorithmus einerseits selbstständig (im Wesentlichen ohne Operator) arbeitet und zugleich kontrollierbar und verbesserungsfähig bleibt.

Gemäß einem weiteren Ausführungsbeispiel ist i) der selbstlernende Algorithmus eingerichtet basierend auf dem Vergleichen einen neuen vorbestimmten Prozessparameter zu bestimmen und automatisch der Datenmodell-Einheit zuzuführen und/oder ii) der selbstlernende Algorithmus ist eingerichtet basierend auf dem Vergleichen einen neuen vorbestimmten Prozessparameter zu bestimmen und dem Benutzer zum Überprüfen bereitzustellen. Dadurch kann sich ebenfalls der Vorteil ergeben, dass der selbstlernende Algorithmus einerseits selbstständig (im Wesentlichen ohne Operator) arbeitet und zugleich kontrollierbar und verbesserungsfähig bleibt.

Gemäß einem weiteren Ausführungsbeispiel ist der selbstlernende Algorithmus eingerichtet, das Ergebnis des Überprüfens durch den Benutzer als Lerngrundlage zu verwenden. Dies kann den Vorteil bereitstellen, dass sich der selbstlernende Algorithmus während dem Betreiben des Verfahrens ständig in einer gewünschten Richtung weiterentwickelt und über die Zeit immer mehr Aufgaben direkt umsetzen kann.

Im Folgenden werden exemplarische Ausführungsbeispiele der vorliegenden Erfindung mit Verweis auf die folgenden Figuren detailliert beschrieben.
Die **Figuren 1 bis 3** zeigen jeweils eine Übersicht der Teilströme beim Herstellen von Leiterplatten und/oder Substraten gemäß Ausführungsbeispielen der Erfindung.
Die **Figuren 4** **und** **5** zeigen einen dritten Aufbereitungsprozess eines Metallsalz-haltigen Mediums aus Spülwasser aus der Leiterplatten- und/oder Substrat-Herstellung gemäß Ausführungsbeispielen der Erfindung.
Die **Figur 6** zeigt eine Übersicht der Aufbereitungsprozesse und des Rückgewinnens bei der Leiterplatten- und/oder Substrat-Herstellung gemäß einem Ausführungsbeispiel der Erfindung.
Die **Figur 7** zeigt eine Prozesskontrollvorrichtung zum Regulieren von zumindest einem Teil des oben beschriebenen Verfahrens (bzw. der Industrieanlage) gemäß einem Ausführungsbeispiel der Erfindung.

Gleiche oder ähnliche Komponenten in unterschiedlichen Figuren sind mit gleichen Bezugsziffern versehen.

Im Folgenden wird ein Prozess beschrieben zum Herstellen von Leiterplatten und/oder Substraten, welcher in einer Industrieanlage, beispielsweise einer Leiterplattenfabrik, durchgeführt wird. Der Begriff "Leiterplatten" kann sich insbesondere auf gedruckte Leiterplatten (printed circuit board (PCB)) beziehen, während sich der Begriff "Substrate" z.B. auf Substrate für Halbleiter-Chips wie integrierte Schaltkreise oder organische Interposer beziehen kann. Dieser Prozess ermöglicht es, dass anfallende Rückstände der Leiterplatten- und/oder Substrat-Herstellung in Teilströmen derart in einem Wertstoffkreislauf transportiert und rückgeführt werden können, dass im Betriebszustand des Verfahrens zum Herstellen von Leiterplatten und/oder Substraten als Abfall (im Wesentlichen) letztlich nur ein Medium in Einleitqualität (insbesondere in Kläranlagen oder Gewässer) anfällt.

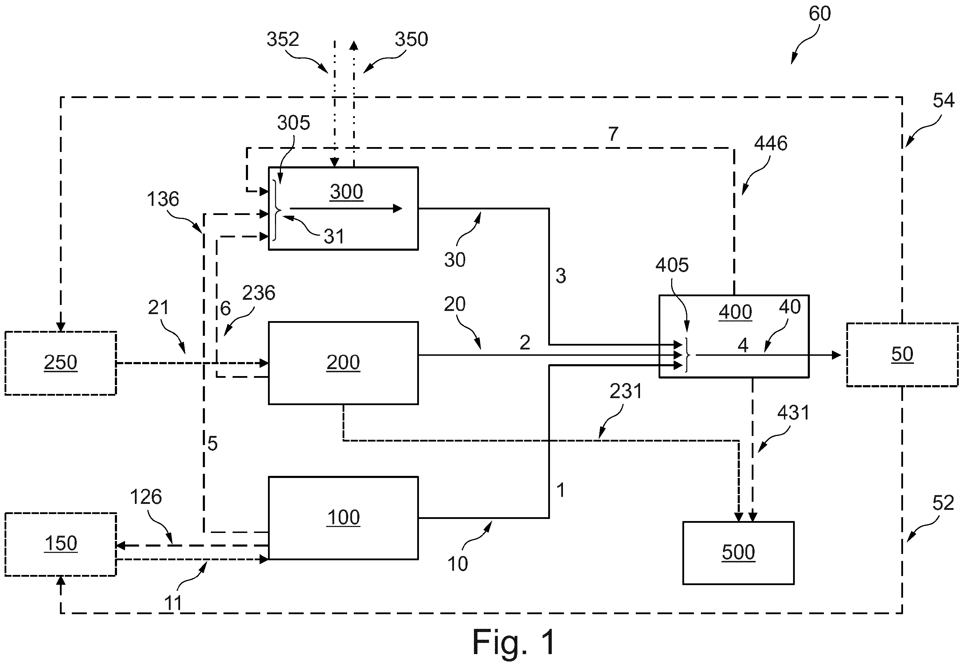

**Figur 1** zeigt eine Übersicht von Strömen 1 bis 7 beim Herstellen von Leiterplatten und/oder Substraten, z.B. in einer Industrieanlage 60, gemäß einem Ausführungsbeispiel der Erfindung. Das Verfahren zum Herstellen von Leiterplatten und/oder Substraten wird derart betrieben, dass die anfallenden Prozess-Rückstände 11, 21, 31 in drei hauptsächlichen Teilströmen 1, 2, 3 (und insbesondere zumindest teilweise als Gesamtstrom 4) und drei hauptsächlichen Abtrennströmen 5, 6, 7 (welche insbesondere Säure-Rückstände aufweisen) derart in einem Wertstoffkreislauf geleitet und rückgeführt (bzw. recycelt) werden, dass in dem (gezeigten) Betriebszustand des Herstellungsverfahrens als Abfall (im Wesentlichen) nur ein Medium 350 in Einleitqualität anfällt. In anderen Worten weist das Medium 350 in Einleitqualität (im Wesentlichen) keine Hauptkomponenten (insbesondere kein Schwermetall) der

Leiterplatten/Substrat-Herstellung mehr auf, sondern besteht lediglich aus Wasser, Salzen, und organischem Material. Dem Herstellungsverfahren müssen im (gezeigten) Betriebszustand (im Wesentlichen) also nur Wasser 352 und Energie zugeführt werden (anfallende Säure-Rückstände werden (im Wesentlichen) ebenfalls in dem Wertstoffkreislauf rückgeführt). Im Wesentlichen werden dem Herstellungsverfahren also nur solche Hauptkomponenten (insbesondere Schwermetall wie Kupfer) zugeführt, welche als Bestandteil einer fertigen gedruckten Leiterplatte und/oder eines Substrats das Herstellungsverfahren wieder verlassen. Prinzipiell können in dem beschriebenen Wertstoffkreislauf 95% oder mehr, insbesondere 98% oder mehr, der Schwermetall-Rückstände (z.B. Kupfer Rückstände) rückgeführt werden. In einem exemplarischen Beispiel des Wertstoffkreislauf werden mindestens 80% (insbesondere mindestens 85%, weiter insbesondere mindestens 90%) der abgetrennten Salzsäure rückgeführt, und mindestens 70% (insbesondere mindestens 75%, weiter insbesondere mindestens 80%) der benötigten Schwefelsäure Verfahrens-intern produziert. Daher werden dem Herstellungsverfahren (im Wesentlichen) keine Hauptkomponenten zugegeben, welche als Abfall das Herstellungsverfahren verlassen haben. Tatsächlich fällt ein solcher Abfall (im Wesentlichen) prinzipiell nicht an.

Die anfallenden Rückstände 11, 21, 31 bzw. Abfallkonzentrate können als aufzubereitende Metallsalz-haltige Medien bezeichnet werden und weisen in einem exemplarischen Ausführungsbeispiel u.a. auf: Kupfer, Kupfersulfat, Kupferchlorid, Eisen, Nickel, Gold, Salzsäure, Schwefelsäure. Die aufzubereitenden Metallsalz-haltigen Medien 11, 21, und 31 werden jeweils in einem entsprechenden Aufbereitungsprozess 100, 200, 300 aufbereitet und dann als Teilströme 1, 2, 3, welche jeweils aufbereitetes Metallsalz-haltiges Medium 10, 20, 30 aufweisen, einem Rückgewinnungsprozess 400 zugeführt. Nach der Aufbereitung schließlich wird rückgewonnenes, elementares Metall 50 wieder in den Herstellungsprozess eingespeist (Pfeile 52 und 54). Im Folgenden wird ein prinzipieller Überblick über die Teilströme 1 bis 7 innerhalb des Wertstoffkreislaufs gegeben. Weiter unten folgen dann detaillierte Beschreibungen der einzelnen Prozesse.

Der erste Teilstrom 1 weist ein erstes aufbereitetes Metallsalz-haltiges Medium 10 aus einem Ätzprozess 150 der Leiterplatten- und/oder Substrat-Herstellung auf, welches in einem ersten Aufbereitungsprozess 100 aufbereitet wird. Das erste aufbereitete Metallsalz-haltige Medium 10 (welches im Wesentlichen kein aufzubereitendes Metallsalz aufweist) wird aus dem aufzubereitenden Medium 11 aus dem Ätzprozess 150 erhalten. Das aufzubereitende Medium 11 weist ein aufzubereitendes Metallsalz (z.B. Kupferchlorid) und eine Säure auf. Das Aufbereiten 100 umfasst ein mehrstufiges Entfernen 110, 120 der Säure mittels Membrandialyse und Durchführen einer chemischen Reaktion 140. Bei der Membrandialyse fällt ein erstes Säure-haltiges Diffusat 136 an. Ein weiteres Säure-haltiges Diffusat 126 kann direkt an den Ätzprozess 150 bereitgestellt werden.

Der zweite Teilstrom 2 weist ein zweites aufbereitetes Metallsalz-haltiges Medium 20 aus einem Galvanisierungsprozess 250 der Leiterplatten- und/oder Substrat-Herstellung auf. Das zweite aufbereitete Metallsalz-haltige Medium 20 (welches im Wesentlichen kein Eisen aufweist) wird aus einem Eisen- und Metallsalz-haltigen Medium 21 aus dem Galvanisierungsprozess 250 erhalten. Das Aufbereiten 200 umfasst ein Separieren des Eisens aus dem Eisen- und Metallsalz-haltigen Medium 21 mittels eines Ionentauschers 220. Bei einem Regenerieren 222 des Ionentauschers 220 fällt ein zweites Säure-haltiges Diffusat 236 an.

Der dritte Teilstrom 3 weist ein drittes aufbereitetes Metallsalz-haltiges Medium 30 aus Spülwasser 32 bzw. einer Spülwasser Mischung 31 der Leiterplattenund/oder Substrat-Herstellung auf. Das dritte aufbereitete Metallsalz-haltige Medium 30 wird in einem dritten Aufbereitungsprozess 300 unter Verwenden eines Ionentauschers 320 erhalten, wobei das Metallsalz in dem aufbereiteten Metallsalz-haltigen Medium 30 im Vergleich zu dem Spülwasser 32 aufkonzentriert ist.

Die Teilströme 1, 2, 3 können (zumindest teilweise) vereint werden (siehe Schritt 405) zu einem Gesamtstrom 4 oder auch einzeln aufbereitet werden. Das Aufbereiten 400 umfasst ein Rückgewinnen 400 des elementaren Metalls 50 (z.B. elementares Kupfer) aus dem Metallsalz-haltigen Medium 40 in einer (Elektrolyse-) Reaktionszelle 450. Das (kontinuierliche) Einstellen der Zusammensetzung des Metallsalz-haltigen Mediums 40 als Elektrolyten umfasst ein Abtrennen 440 von Säure mittels Membrandialyse, wobei ein drittes Säure-haltiges Diffusat 446 anfällt. Alternativ kann das Diffusat 446 auch zur Regeneration eines Ionentauschers 320 zur Aufbereitung der Spülwässer herangezogen werden. Hierbei bleibt das Metall (insbesondere Kupfer) ebenfalls im Wertstoffkreislauf und kann daher nahezu vollständig aus dem Metallsalz-haltigen Medium entfernt werden. Das hat den Vorteil, dass ein weiterer Aufbereitungsschritt mittels Membrandialyse eingespart werden kann. Das erhaltene hochreine Metall 50 wiederum ist geeignet erneut in den Ätzprozess 150 rückgeführt (siehe Pfeil 52) zu werden und/oder in den Galvanisierungsprozess 250 rückgeführt (siehe Pfeil 54) zu werden.

Ein erster Abtrennstrom 5 stammt aus dem ersten Aufbereitungsprozess 100 und weist das erste Säure-haltige Diffusat 136 auf. Ein zweiter Abtrennstrom 6 stammt aus dem zweiten Aufbereitungsprozess 200 und weist das zweite Säure-haltige Diffusat 236 auf. Ein dritter Abtrennstrom 7 stammt aus dem Aufbereitungsprozess 410 des Gesamtstroms 4 und weist das dritte Säure-haltige Diffusat 446 auf. Die Abtrennströme 5, 6, 7 weisen jeweils das Metallsalz (z.B. Kupfersulfat) in geringer Konzentration auf, bzw. in geringerer Konzentration als die Konzentration des Metallsalzes in dem dritten Teilstrom 3. Die Abtrennströme 5, 6, 7 werden (zumindest teilweise) zusammengeführt (siehe Schritt 305) zu einem aufzubereitenden Medium 31 bzw. einer Mischung an Spülwässern (Gesamtabtrennstrom). Auch weitere Spülwässer 32 des Herstellungsverfahrens können hier einfließen. Das aufzubereitende Medium 31 wird, wie oben beschrieben, mittels des dritten Aufbereitungsprozesses 300 aufbereitet, um die Konzentration für das Rückgewinnen 400 deutlich zu erhöhen.

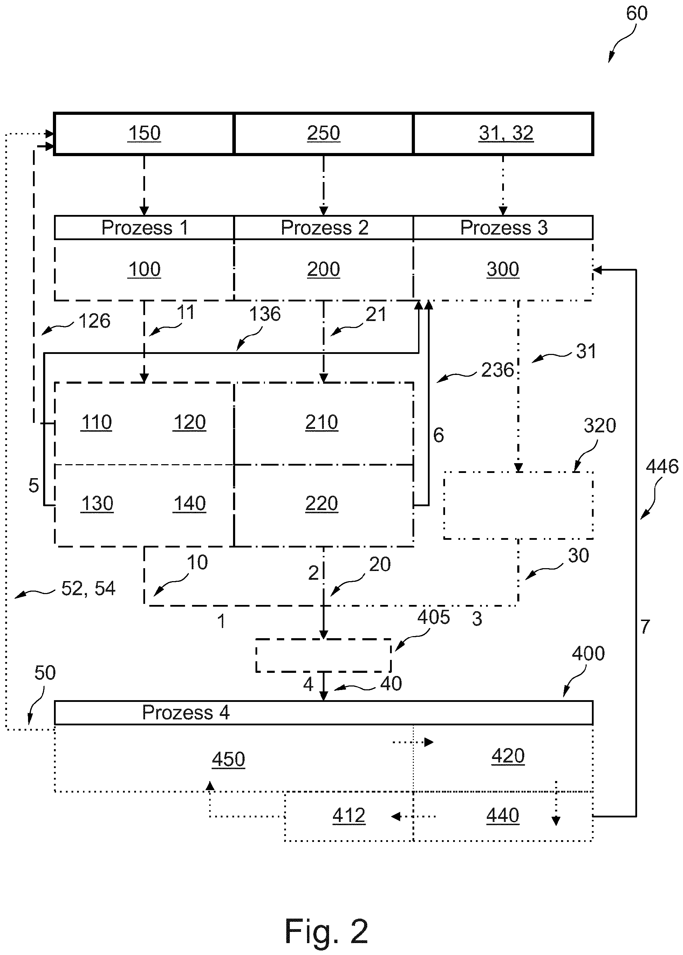

**Figur 2** zeigt eine Übersicht der Teilströme beim Herstellen von Leiterplatten und/oder Substraten, z.B. in einer Industrieanlage 60, gemäß einem weiteren Ausführungsbeispiel der Erfindung. Der Wertstoffkreislauf entspricht dem für Figur 1 oben beschriebenen in anderer Darstellungsweise. Es ist ferner gezeigt, dass das Rückgewinnen 400 ein (kontinuierliches) Einstellen der Zusammensetzung des Elektrolyten (bzw. des Metallsalz-haltigen Mediums) 40 aufweist. So wird der Elektrolyt aus der Reaktionszelle 450 (kontinuierlich) behandelt mittels eines organischen Filters 412, eines Separierens von Fremdmetall 420, und eines Separierens von Säure 440 (bei zu hoher Säurekonzentration).

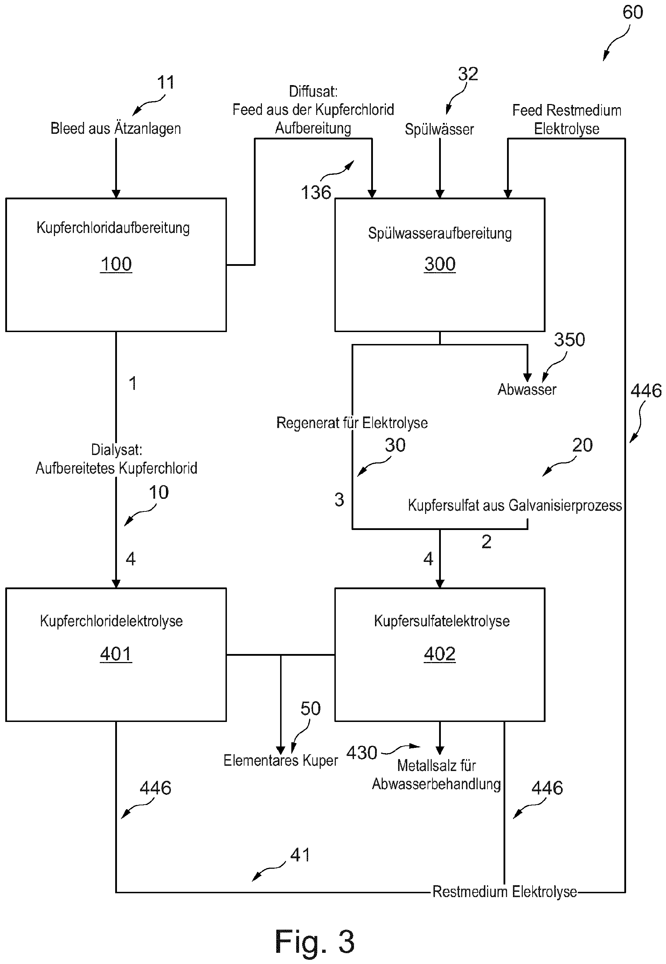

**Figur 3** zeigt ein exemplarisches Ausführungsbeispiel des für die Figuren 1 und 2 bereits beschriebenen Herstellens von gedruckten Leiterplatten und/oder Substraten. In diesem spezifischen Ausführungsbeispiel weist das aufzubereitende Metallsalz Kupferchlorid auf und das Metallsalz weist Kupfersulfat auf. Der Unterschied zu dem für die Figuren 1 und 2 beschriebenen Prozess besteht darin, dass der erste Teilstrom 1 einem ersten Rückgewinnungsprozess 401 (der Begriff "Kupferchloridelektrolyse" bezieht sich hierbei auf das Ausgangsmaterial, es wird eigentlich eine Kupfersulfatelektrolyse durchgeführt) zugeführt wird und ein Gesamtstrom 4, welcher aus dem zweiten Teilstrom 2 und dem dritten Teilstrom 3 besteht, einem zweiten Rückgewinnungsprozess 402 zugeführt wird.

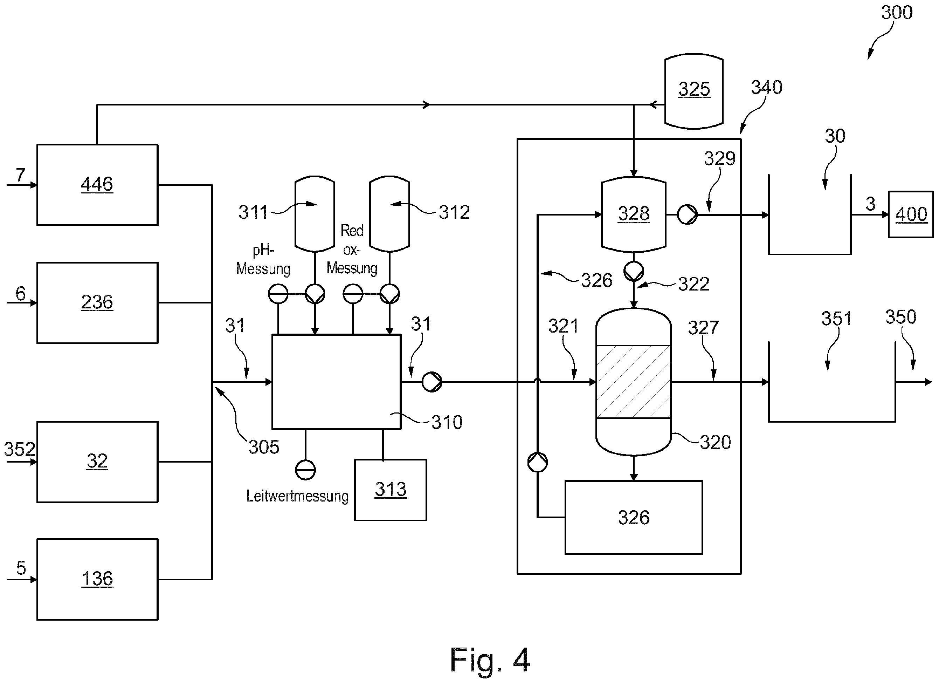

**Figur 4** zeigt den dritten Aufbereitungsprozess 300 gemäß einem Ausführungsbeispiel der Erfindung zum Aufbereiten eines aufzubereitenden Mediums 31 aus Spülwasser aus der Leiterplatten- und/oder Substrat-Herstellung, um ein drittes Metallsalz-haltiges Medium 30 bereitzustellen. Das aufzubereitende Medium 31 wird bereitgestellt (siehe Schritt 305) durch Mischen einer Vielzahl von Spülwässern des Leiterplatten Herstellungsprozesses. Ein erstes Spülwasser ist ein Diffusat 136 aus dem ersten Aufbereitungsprozess 100 zum Aufbereiten von Rückständen aus dem Ätzprozessen 150, welches über den ersten Abtrennstrom 5 bereitgestellt wird. Ein zweites Spülwasser ist ein Diffusat 236 aus dem zweiten Aufbereitungsprozess 200 zum Aufbereiten von Rückständen aus der Galvanik 250, welches über den zweiten Abtrennstrom 6 bereitgestellt wird. Ein drittes Spülwasser ist ein Diffusat 446 aus dem Rückgewinnen 400 von elementarem Metall 50 aus den aufbereiteten Rückständen, welches über den dritten Abtrennstrom 7 bereitgestellt wird. Ferner können noch weitere Spülwässer 32 aus dem Leiterplattenprozess (falls anfallend) bereitgestellt werden. Diese resultieren letztendlich aus dem Prozess zugeführtem Wasser 352. Die beschriebenen Abtrennströme 5, 6, 7, 352 können alle gemischt werden, teilweise gemischt werden, oder separat voneinander aufbereitet werden.

In einem weiteren Ausführungsbeispiel wird der Ionenaustauscher 320 der Spülwässer mit verbrauchtem Elektrolyt 41, der nur noch eine geringe Konzentration an Kupfer aufweist, regeneriert. Während der Elektrolyse 450 entsteht Schwefelsäure, welche vom Elektrolyt 40 abgetrennt werden muss, um die gewünschte Abscheiderate erhalten zu können. Mit steigender Schwefelsäurekonzentration nimmt die Menge an abzuscheidendem Kupfer 50 ab. Würde Säure beispielsweise kontinuierlich mittels Membrandialyse 440 vom Elektrolyten 40 getrennt werden, würde hierfür wieder eine große Menge an Wasser eingesetzt werden. Dies erfordert (Energie-intensive) Maßnahmen wie einen Verdunsterturm, um die Säure in einer geeigneten Konzentration wieder zurückgewinnen zu können. Eine Alternative hierzu ist das Betreiben der Elektrolyse 450 nur so lange, bis der Elektrolyt 40 eine definierte Säure- und Kupfer Konzentration (z.B. Cu²⁺ etwa 5 g/L) erreicht hat. Anschließend kann dieser verbrauchte Elektrolyt 41 für die Regeneration des Ionenaustauschers 320 zur Aufbereitung der Spülwässer 300 herangezogen werden. Dadurch verbleibt das Kupfer im Wertstoffkreislauf und die Säure muss nicht über eine Dialyse 440 in einem zusätzlichen Prozessschritt abgetrennt werden.

In einem exemplarischen Ausführungsbeispiel kann während der Elektrolyse 450 ein großes Volumen Schwefelsäure (z.B. 1000 L pro Tag) anfallen. Dadurch kann (im Wesentlichen) die gesamte Menge an produzierter Schwefelsäure als Regeneriersäure (bzw. Regeneriermedium) für das Aufbereiten 300 von Spülwässern herangezogen werden. Dies kann den Vorteil bereitstellen, dass (im Wesentlichen) keine Schwefelsäure in den Wertstoffkreislauf zugeführt (bzw. zugekauft) werden muss. In einem spezifischen Ausführungsbeispiel kann dennoch mit frischer Schwefelsäure "nachgeschärft" werden.

In einem weiteren Ausführungsbeispiel wird der Überschuss an Schwefelsäure zusätzlich (abgesehen von der Aufbereitung 300 bzw. Regeneration der Spülwässer) in ein Vorbehandlungsbecken 310 der Spülwässer geleitet. Hierin wird die Schwefelsäure zuerst neutralisiert 311 und anschließend dem Ionenaustauschharz 320 zugeführt. Dadurch kann die Restkonzentration an Kupfer (im verbrauchten Elektrolyten 41) in dem Wertstoffkreislauf erhalten und zurückgewonnen werden.

Das (gemischte) aufzubereitende Medium 31 wird einer Vorbehandlung 310 unterzogen, denn es können sehr niedrige pH-Werte vorliegen (durch die starken Säuren in den Diffusaten). Ferner können starke Oxidationsmittel wie Wasserstoffperoxid vorliegen, welche reduziert werden müssen. Einstellen des pH-Werts (bei 311) (Neutralisieren) des aufzubereitenden Mediums 31 kann z.B. mittels Natronlauge auf einen Wert im Bereich 1 bis 3 (insbesondere 2) durchgeführt werden. Chemisches Reduzieren (bei 312) des aufzubereitenden Mediums 31 gelingt mittels eines Reduktionsmittels, beispielsweise Bisulfit.

Sowohl ein stark saurer pH-Wert als auch starke Oxidationsmittel wie Wasserstoffperoxid greifen das Ionenaustauschharz an. Insbesondere Wasserstoffperoxid zersetzt sukzessive das Harz. Bevorzugt wird bei Ionenaustauschharz für Spülwässer, aus welchen Wasserstoffperoxid bereits im Wesentlichen entfernt wurde, ein mit Iminodiessigsäure-funktionalisiertes Polystyrol verwendet. Im Falle von Spülwässern, aus welchen Wasserstoffperoxid nicht entfernt wurde, wird bevorzugt ein Wasserstoffperoxid-beständiges (bzw. Oxidationsmittel-beständiges) Harz mit einem Trägermaterial aus Polystyrol verwendet, welches zusätzlich noch mittels Divinylbenzol quervernetzt ist. Diese zusätzliche Quervernetzung schützt das Polymer effektiv vor dem Oxidationsmittel. Dieses Harz kann in einem exemplarischen Beispiel mit einer maximalen Konzentration an 20g/L Wasserstoffperoxid beladen werden.

Zusätzlich oder alternativ kann das Vorbehandlungsbecken 310 mit einem Aktivkohle-Filter 313 gekoppelt werden, welcher das Wasserstoffperoxid zersetzt. Dies hat den Vorteil, dass zeitgleich und ohne weitere Aufwendungen organische Reste aus den Spülwässern entfernt werden können.

Insbesondere kann der Aktivkohlefilter 313 an das Vorbehandlungsbecken 310 gekoppelt werden, um organische Bestandteile zu filtern. Dies kann den Vorteil bereitstellen, dass ein erwünschter CSB-Wert (und eine entsprechende Einleitqualität) des Mediums erreicht werden kann.

Das eigentliche Aufbereiten wird mittels eines Ionentauscher-Moduls 340 durchgeführt. Zunächst wird ein Ionentauscher 320 mit dem aufzubereitenden Medium 31 derart beladen, dass das Metall, welches das aufzubereitende Medium 31 aufweist, an dem Ionentaucher 320 verbleibt. Dadurch strömt aus dem Ionentauscher 320 ein Abwasser 327, welches im Wesentlichen Wasser, Salz (z.B. Magnesium-, Natrium-, Calcium-Salze), und Organik aufweist und (im Wesentlichen) Schwermetall-frei ist. Dieses Abwasser Medium 350 weist daher eine Einleitqualität in Kläranlagen auf. Die Konzentration an Schwermetall ist 15 mg/L oder weniger, insbesondere ist die Konzentration an Kupfer 0,5 mg/L oder weniger (und liegt damit z.B. innerhalb der gesetzlichen Grenzwerte der Republik Österreich). Das Abwasser Medium 350 in Einleitqualität wird derart aufgereinigt (z.B. in einer Prozess-internen Kläranlage 351), dass das Medium in Gewässer einleitbar ist. Diese Aufreinigung bezieht sich nicht auf Schwermetalle, sondern auf Organik-Reste. Diese können z.B. über Aktivkohlefilter einfach entfernt werden. Beispielsweise kann nach dem Aufreinigen (351) der CSB (chemischer Sauerstoffbedarf)-Wert, als Maß für die Konzentration organischer Verbindungen, in dem Medium in Einleitqualität 350 weniger als 300 mg/L, insbesondere weniger als 75 mg/L (weiter insbesondere weniger als 65 mg/L), betragen. Der CSB Wert kann hierbei die Menge an Sauerstoff (in mg/L) angeben, die zu der Oxidation der oxidierbaren Stoffe benötigt würde, wenn Sauerstoff das Oxidationsmittel wäre. Beispielsweise in Österreich liegt dieser Grenzwert per Gesetz bei 75 mg/L. Der CSB-Grenzwert für Kläranlagen kann stark variieren, und beträgt in einem Beispiel 300 mg/L.

In einem exemplarischen Beispiel ist der Ionenaustauscher 320 zweistufig aufgebaut. Der nachgeschaltete (zweite) Ionenaustauscher nimmt den Kupferrest des vorangeschalteten (zu beladenden) Ionenaustauschers auf und dient als Absicherung zur Einhaltung der Schwermetall-Grenzwerte (siehe Einleitqualität). Weist der erste Ionentauscher einen erhöhten Kupferrest auf, kann dieser regeneriert und anschließend an die nachgeschaltete (zweite) Stelle geschaltet werden (siehe hierzu auch die Beschreibung des Ionentauschers 220 oben).

Danach findet ein Regenerieren 322 des Ionentauschers 320 statt mittels Strömens eines Regeneriermediums 325, 326 durch den Ionentauscher 320. Dadurch wird das Metall zumindest teilweise in dem Regeneriermedium 325, 326 gelöst und ein Regenerat 326 wird bereitgestellt. Zunächst kann der Ionentauscher 320 von einer weiteren Säure 325 (z.B. Schwefelsäure) als Regeneriermedium 325 durchströmt (bei 322) werden. Die weitere Säure 325 kann direkt bereitgestellt werden und/oder aus einem Abtrennstrom 5, 6, 7 der Leiterplatten- und/oder Substrat-Herstellung stammen, insbesondere aus dem Verfahren zum Rückgewinnen (bzw. Erzeugen) 400 (Diffusat 446 über den dritten Abtrennstrom 7). Um eine erwünschte Effizienz zu gewährleisten, soll bevorzugt das Regeneriermedium 325, 326 (zumindest teilweise) Verfahrens-intern erzeugt sein. Damit ist also ein Rückgewinnen des Regeneriermediums 325, 326 vorgesehen. Daher ergibt sich für das Regeneriermedium eine Zusammensetzung aus weiterer Säure 325 und Regenerat 326. Das erhaltene Regenerat 326 weist neben der Regeneriersäure eine Metall-Konzentration (z.B. Kupfer, in Schwefelsäure als Kupfersulfat vorliegend) auf. Diese Konzentration kann durch mehrere Regenerierschritte 322 deutlich erhöht werden, so dass entsprechend eine Mehrzahl von Regenerierschritten vorgesehen sind. Diese Anforderung deckt sich vorteilhaft mit dem erwünschten Rückgewinnen des Regeneriermediums 325, 326. Das erhaltene Regenerat 326 wird einem Regenerat Speicher-Modul 328 zugefügt. Dort kann es, falls notwendig, mit weiterer Säure 325 gemischt werden. Von dem Regenerat Speicher-Modul 328 durchströmt (bei 322) das Regenerat 326, welches bereits eine Metall-Konzentration aufweist, ein zweites Mal den Ionentauscher 320. Dabei wird die Metall-Konzentration erneut erhöht durch Metall, welcher noch an dem Ionentauscher 320 adsorbiert war. Nach diesem zweiten Regenerierschritt 322 folgt ein dritter Regenerierschritt 322 mit dem Regenerat 326, so dass nachfolgend einer Mehrzahl von Regenerierschritten (z.B. fünf oder mehr) die Metall-Konzentration im Regenerat 326 immer weiter ansteigt, während immer weniger Metall in dem Ionentauscher 320 verbleibt. Wenn eine erwünschte (Metall) Mindestkonzentration in dem Regenerat 326 erreicht ist, kann das Regenerat 326 dem Ionentauscher-Modul 340 als Metallsalz-haltiges Medium 30 entzogen werden (Pfeil 329). Das Metallsalz-haltige Medium 30 kann dann über den dritten Teilstrom 3 einem Verfahren zum Rückgewinnen 400 des elementaren Metalls 50 aus dem Metallsalz-haltigen Medium 30 zugeführt werden. Mit Vorteil wird das beschriebene Aufbereitungsverfahren 300 kontinuierlich betrieben.

Gemäß einem exemplarischen Ausführungsbeispiel enthalten aufzubereitende Medien 31 (Abfallkonzentrate) aus den Spülwässern der Leiterplatten- und/oder Substrat-Herstellung vergleichsweise nur geringe Konzentrationen an Kupfer, welche in Form von Kupfersulfat vorliegen. Das vorliegende Kupfer wird daher mittels eines selektiven Ionenaustauschharzes 320 (selektiv für Kupfer) von den Abfallkonzentraten 31 getrennt. Das am Harz immobilisierte Kupfer wird anschließend über eine spezielle Regeneriertechnik gelöst. Während konventionell Harze mittels Salzsäure bei einem maximalen Gehalt von 1,5 bis 8 Gewichtsprozent regeneriert werden, haben die Erfinder überraschend festgestellt, dass die Regeneration 322 auch mit stark konzentrierten Säuren effizient durchführbar ist. Daher kann das Kupfer z.B. mittels konzentrierter Schwefelsäure 325 vom Harz gelöst werden.

In einem exemplarischen Ausführungsbeispiel werden folgende Parameter verwendet: H₂SO₄ Konzentration: ca. 1,5-8 Gewichtsprozent; H₂SO₄ Menge (Gleichstrom): mindestens 120 g/L Harz; und H₂SO₄ Menge (Gegenstrom): mindestens 80 g/L Harz. Insbesondere kann aber eine SchwefelsäureKonzentration von etwa 25 Gewichtsprozent verwendet werden, die nach dem ersten Regenerieren auf ca. 20 Gewichtsprozent sinkt. Das Regenerieren wird bevorzugt im Gegenstrom betrieben, um die Menge an benötigter Säure für die Regeneration geringstmöglich zu halten. Das Einsparungspotential kann ca. 30% Säure betragen, wenn im Gegenstrom regeneriert wird.

Die somit generierte Kupfersulfat-Lösung als Regenerat 326 kann direkt für die Rückgewinnung 400 herangezogen werden. Dadurch kann das Volumen an Schwefelsäure 325, das zur Regeneration 322 des Harzes benötigt wird, geringgehalten werden. Die volumengesteuerte Regeneration 322 mittels konzentrierter Schwefelsäure 325, 326 funktioniert kontinuierlich oder diskontinuierlich. Das Harz wird daher nach der Immobilisierung des Kupfers abgesenkt und gespült, bevor das Harz mit konzentrierter Schwefelsäure regeneriert 322 werden kann. Die Schwefelsäure 325, 326 wird für mehrere Regenerationsschritte 322 verwendet (rückgewonnen), um eine ausreichend hohe Konzentration an Kupfer im Metallsalz-haltigen Medium 30 zu erzielen. Im Vergleich zu konventionellen Regeneriertechniken fällt nur wenig flüssiges Medium an und es muss kein Wasser mehr aus dem Regenerat 326 entfernt werden.

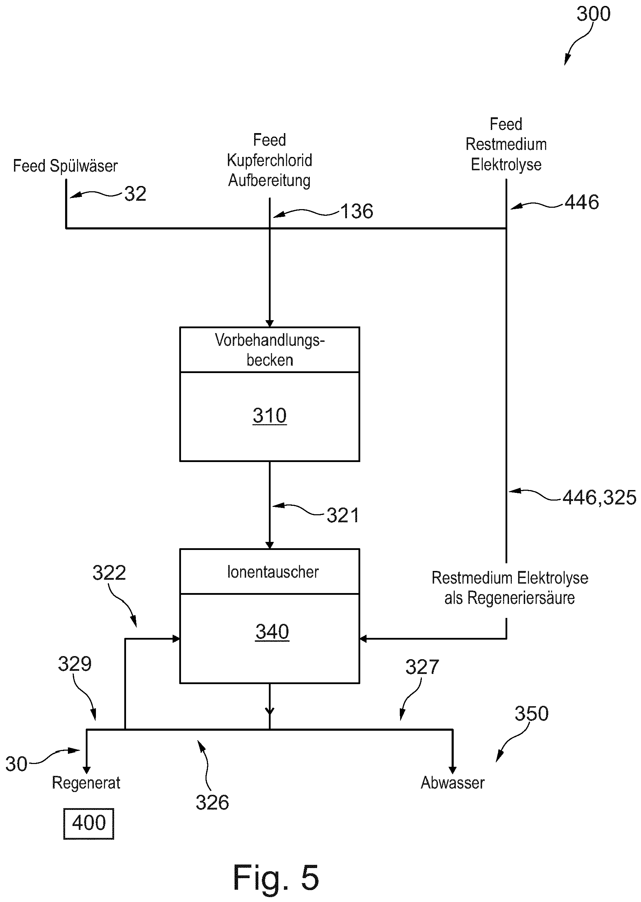

**Figur 5** zeigt den dritten Aufbereitungsprozess 300 des Metallsalz-haltigen Mediums aus einem Spülprozess aus der Leiterplatten- und/oder Substrat-Herstellung, welcher in Figur 4 im Detail beschrieben wurde, nochmals aus Gründen der Übersicht als Flussdiagram.

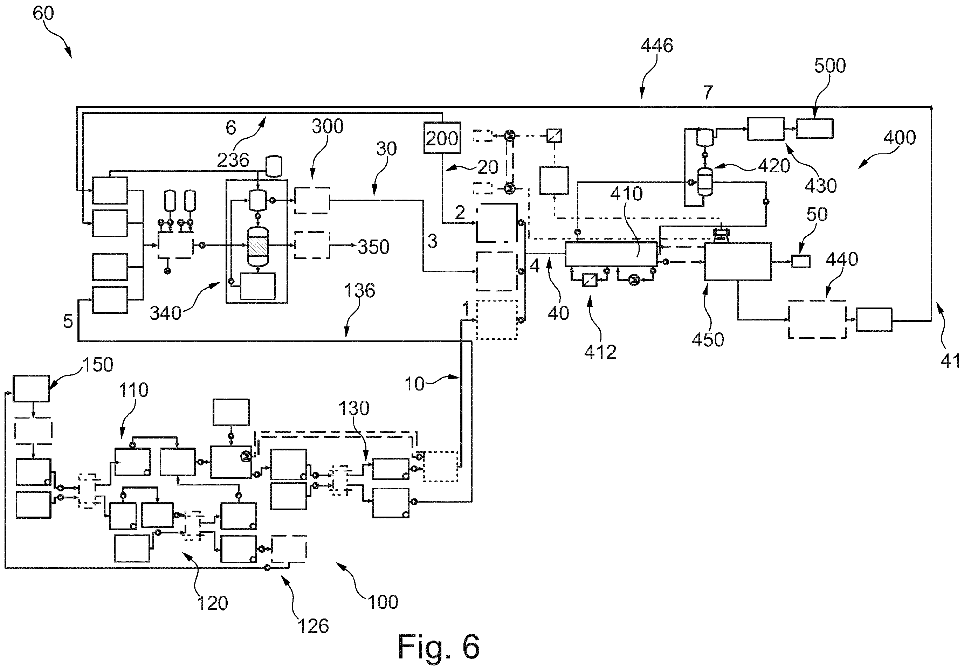

**Figur 6** zeigt eine Übersicht der Aufbereitungsprozesse 100, 200, 300 und des Rückgewinnens 400 bei der Leiterplatten- und/oder Substrat-Herstellung gemäß einem Ausführungsbeispiel der Erfindung. Die Übersicht zeigt die Verzahnung sämtlicher Prozesse ineinander und den sich hieraus ergebenden Wertstoffkreislauf. Die Prozesse wurden für die oben ausgeführten Ausführungsbeispiele jeweils bereits im Detail diskutiert.

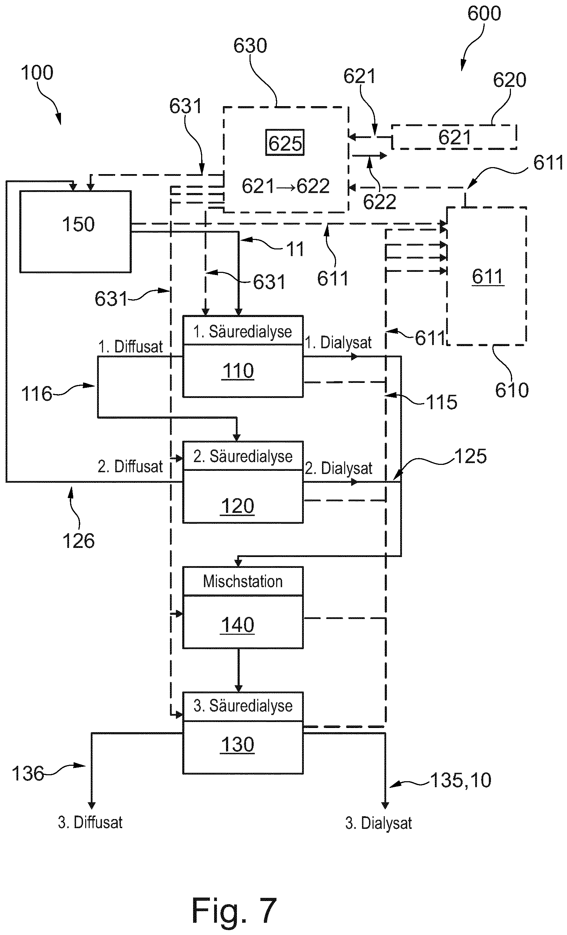

**Figur 7** zeigt eine Prozesskontrollvorrichtung 600 zum Regulieren (bzw. Regeln) von zumindest einem Teil des oben beschriebenen Verfahrens (bzw. der Industrieanlage 60) gemäß einem Ausführungsbeispiel der Erfindung. In dem gezeigten Beispiel ist die Prozesskontrollvorrichtung 600 in den ersten Aufbereitungsprozess 100 zum Bereitstellen des ersten Metallsalz-haltigen Mediums 10 aus einem Ätzprozess 150 aus der Leiterplatten- und/oder Substrat-Herstellung implementiert. Auf dieselbe Weise kann die Prozesskontrollvorrichtung 600 auch in die weiteren (oben beschriebenen) Prozesse (bzw. Verfahren) implementiert werden.

Die Prozesskontrollvorrichtung 600 weist auf: i) eine Datenbank 610 zum Erfassen von zumindest einem Prozessparameter 611 aus dem laufenden (im Betriebszustand befindlichen) Prozess (in dem gezeigten Beispiel der erste Aufbereitungsprozess 100). In dem exemplarischen Ausführungsbeispiel ist gezeigt, dass an allen Prozessschritten Prozessparameter (Werte und/oder Bereiche) 611 erfasst werden (z.B. mittels Sensoren) und der Datenbank 610 zugeführt werden. Die Prozessparameter stellen daher "Ist"-Werte dar (z.B. HCl Konzentration, Kupfer Konzentration, Druckdifferenz, etc). Die Prozesskontrollvorrichtung 600 weist ferner auf: ii) eine Datenmodell-Einheit 620, welche eingerichtet ist zum Speichern von zumindest einem vorbestimmten Prozessparameter 621 (Werte und/oder Bereiche). In dem gezeigten Beispiel werden eine Vielzahl von Prozessparametern gemäß einem oder mehr Datenmodellen in der Datenmodell-Einheit 620 für die verschiedenen Prozessschritte bereitgestellt. Diese vorbestimmten Prozessparameter 621 stellen daher "Soll"-Werte dar. Die Prozesskontrollvorrichtung 600 weist ferner auf: iii) eine Berechnungsvorrichtung 630 (z.B. eine einzelne (separate) Einheit oder eine Mehrzahl von Einheiten), welche eingerichtet ist zum a) Vergleichen des erfassten Prozessparameters 611 (bzw. der Mehrzahl dieser Parameter) mit dem vorbestimmten Prozessparameter 621 (bzw. der Mehrzahl dieser Parameter) (z.B. Vergleich "Ist-Wert" gegen "Soll"-Wert), b) Bestimmen einer Steueroperation 631, welche auf dem Ergebnis des Vergleichens basiert (beispielsweise aktives Ausgleichen einer Differenz zwischen "Ist"-Wert und "Soll"-Wert), und c) Durchführen der bestimmten Steueroperation 631 (z.B. Flussrate anpassen).

Gemäß einem exemplarischen Ausführungsbeispiel der (Software-basierten) Prozesskontrollvorrichtung 600 sammelt die Datenbank 610 Daten aus dem laufenden Prozess (Prozessparameter 611) bzw. greift auf Werte aus einem vorgelagerten Prozessschritt (Prozessparameter 611) zu und archiviert daher (alle) "Ist"-Werte. Ein Datenmodell bzw. mehrere voneinander unabhängige Datenmodelle (welche(s) in der Datenmodell-Einheit 620 z.B. ebenfalls in Form einer Datenbank angelegt sind/ist) beinhalten u.a. "Soll"-Werte (bzw. "Soll"-Bereiche), optional auch deren Zusammenhänge und Variablen (z.B. Datenmodelle 621 als Referenzwerte/Referenzmodelle, die zur Überprüfung der "Ist"-Werte 611 herangezogen werden). Die Berechnungsvorrichtung 630 gleicht die "Ist"-Werte mit den "Soll"-Werten (bzw. setzt einen Rechenschritt basierend auf den Datenmodellen 621 in Kombination mit den "Ist"-Werten 611) ab und setzt anschließend eine Aktion (Steueroperation 631) entsprechend dem Abgleichergebnis (z.B. "Ist"-Wert entspricht "Soll"-Wert, "Ist"-Wert weicht von "Soll"-Wert ab, "Ist"-Wert erfüllt bestimmte Kriterien, etc). Die bestimmte Steueroperation 631 kann (zumindest einen Teil) eines Verfahrensschritts wie oben beschrieben aufweisen.

Gemäß einem exemplarischen Ausführungsbeispiel weist die Berechnungsvorrichtung 630 einen selbstlernenden Algorithmus (AI) 625 (z.B. realisiert mittels neuronaler Netzwerke) auf zum Vergleichen und/oder zum Bestimmen. Der selbstlernende Algorithmus 625 ist eingerichtet, die bestimmte Steueroperation 631 automatisch durchzuführen und/oder einem Benutzer zum Überprüfen bereitzustellen. Ferner ist der selbstlernende Algorithmus 625 eingerichtet basierend auf dem Vergleichen einen neuen vorbestimmten Prozessparameter 622 zu bestimmen und diesen automatisch der Datenmodell-Einheit 620 zuzuführen und/oder dem Benutzer zum Überprüfen bereitzustellen. Bevorzugt ist der selbstlernende Algorithmus 625 eingerichtet, das Ergebnis des Überprüfens durch den Benutzer als Lerngrundlage zu verwenden.
Gemäß einem exemplarischen Ausführungsbeispiel weist die Berechnungseinheit 630 einen selbstlernenden Algorithmus 625 auf, der Aktionen (Steueroperationen 631) setzt, welche entweder direkt im System implementiert werden oder die dem Operator zur Überprüfung zur Verfügung gestellt werden. Zudem kann die Entscheidung des Operators bei der Überprüfung wiederum die Lerngrundlage für die AI-Funktion bilden. Ferner kann die AI basierend auf den erfassten "Ist"-Werten 611 neue "Soll"-Werte/Bereiche 621 kreieren bzw. vorschlagen, die dann entweder automatisch oder Operator-gesteuert in das Datenmodell übernommen werden.

In einem spezifischen Ausführungsbeispiel werden die folgenden Prozessparameter 611 überwacht bzw. gemessen (im Folgenden angegeben ist jeweils eine beispielhafte Messmethode) und in der Datenbank 610 erfasst:
i) Füllstände; mittels Ultraschallmessungen,
ii) Volumenströme; mittels Flowmeter,
iii) H₂O₂ Konzentration; über das Redoxpotential bestimmt,
iv) Säure Konzentration; pH Wert (in-line) oder Titration (Proben ziehen),
v) Organik Konzentration; photometrisch (in-line) oder Cyclovoltammetrie (Proben ziehen),
vi) Chlorid Konzentration; Titration (Proben ziehen),
vii) Eisen/Kupfer Konzentration; photometrisch oder Dichtemessungen (in-line) oder Titration (Proben ziehen),
viii) Temperatur; Temperatursensoren (in-line),
ix) Differenzdruck bei der Membrandialyse zwischen Diffusat und Dialysat; Drucksensoren (in-line).

In diesem spezifischen Ausführungsbeispiel werden nach dem Vergleichen (bzw. Auswerten, Datenanalyse) der bestimmten (gemessenen) Prozessparameter 611 und der vorbestimmten Prozessparameter 621 durch die Berechnungsvorrichtung 630 mittels der Berechnungsvorrichtung 630 z.B. die folgenden Steueroperationen 631 (bzw. Aktionen) bestimmt und durchgeführt (bzw. getriggert):
i) Chlorgas-Bildung (z.B.: über Gassensoren); Steueroperation: Elektrolyse aus,
ii) zu hohe Peroxidbelastung; Steueroperation: kein Beladen des Ionentauschers zur Aufbereitung der Spülwässer,
iii) zu niedriger Füllstand; Steueroperation: Pumpen aus,
iv) zu hohe Eisenkonzentration im Elektrolyten; Steueroperation: Zuschalten des Ionenaustauschharzes,
v) zu hohe Säure-Konzentration im Elektrolyten; Steueroperation: Zuschalten der Membrandialyse oder Abpumpen der Elektrolysezelle,
vi) geringe Kupfer-Konzentration im Elektrolyten; Steueroperation: Elektrolysezelle abpumpen und Fördern des Elektrolyten zum Vorbehandlungsbecken der Spülwässer,
vii) zu hoher Differenzdruck bei Membrandialyse; Steueroperation: Volumenströme (Flowrate) anpassen,
viii) Kupfer-Konzentration im Permeat des Ionentauschers zur Aufbereitung der Spülwässer; Steueroperation: Regenerieren,
ix) Eisen-Konzentration im Permeat des Ionentauschers zur Eliminierung von Eisen aus den Galvanikabwässer; Steueroperation: Regenerieren,
x) zu hohe Chlorid-Konzentration im Dialysat; Steueroperation: Volumenströme (Flowrate) anpassen.

### Bezugszeichen

1, 2, 3 Erster Teilstrom, zweiter Teilstrom, dritter Teilstrom
4 Gesamtstrom
5, 6, 7 Erster Abtrennstrom, zweiter Abtrennstrom, dritter Abtrennstrom
52 Metall Rückführung zu Ätzprozess
54 Metall Rückführung zu Galvanisierungsprozess
60 Industrieanlage zum Herstellen gedruckter Leiterplatten
100 Aufbereitung eines Metallsalz-haltigen Mediums aus einem Ätzprozess aus der Herstellung gedruckter Leiterplatten
10 Metallsalz-haltiges Medium
11 Aufzubereitendes Medium
15 Säure
15a Erster Teil Säure
15b Zweiter Teil Säure
15c Dritter Teil Säure
110 Erste Membrandialyse
112 Erste Membran
113 Erster Zulauf
115 Erstes Dialysat
116 Erstes Diffusat
120 Zweite Membrandialyse
122 Zweite Membran
123 Zweiter Zulauf
125 Zweites Dialysat
126 Zweites Diffusat
127 Ätzprozess Sammelbecken
130 Dritte Membrandialyse
131 Zulauf für Dialysat
132 Dritte Membran
133 Dritter Zulauf
135 Drittes Dialysat
136 Drittes Diffusat (erster Abtrennstrom)
140 Reaktor, Mischen und Durchführen der chemischen Reaktion
141 Konzentriertes (Säure-freies) aufzubereitendes Medium
143 Weitere Säure
150 Ätzprozess
151 Ätzprozess Überlaufbecken
160 Verdunster
200 Aufbereitung eines Metallsalz-haltigen Mediums aus einem Galvanisierungsprozess aus der Herstellung gedruckter Leiterplatten
20 Metallsalz-haltiges Medium
21 Eisen- und Metallsalz-haltiges Medium
205 Speicher-Modul, Bereitstellen
210 Oxidier-Modul
220 Separier-Modul, Ionentauscher
221 Beladen
222 Regenerieren, Strömen
225 Saure Lösung
226 Eisen-haltige saure Lösung, Regenerat
230 Aufbereiten, Säuredialyse
231 Bereitstellen an Leiterplatten Prozess
235 Eisen-haltiges Dialysat
236 Säure-haltiges Diffusat (zweiter Abtrennstrom)
240 Rückführen Säure
250 Galvanisierungsprozess
300 Aufbereitung eines Metallsalz-haltigen Mediums aus Spülwasser aus der Herstellung gedruckter Leiterplatten
30 Metallsalz-haltiges Medium
31 Aufzubereitendes Medium, Gesamtabtrennstrom
32 Weiteres Spülwasser
305 Bereitstellen
310 Vorbehandeln
311 Behälter Natronlauge, Einstellen pH-Wert
312 Behälter Bisulfit, chemisches Reduzieren
313 Organik-Filter, Aktivholefilter
320 Ionentauscher
321 Beladen
322 Regenerieren, Strömen
325 Regeneriermedium, weitere Säure
326 Regeneriermedium, Regenerat
327 Separieren von Abwasser
328 Speicher-Modul für Regenerat
329 Bereitstellen von konzentriertem Medium
340 Separier-Modul
350 Abfall Medium, Wasser mit Einleitqualität
351 Aufreinigung Wasser
352 Zufuhr Wasser
400 Rückgewinnen eines elementaren Metalls aus einem Metallsalzhaltigen Medium aus der Herstellung gedruckter Leiterplatten
40 Metallsalz-haltiges Medium, Elektrolyt
41 Verbrauchter Elektrolyt
50 Elementares Metall (Kupfer)
401 Rückgewinnen erster Teilstrom
402 Rückgewinnen zweiter und dritter Teilstrom
405 Bereitstellen, Zusammenführen, Aufkonzentrieren
410 Versorgungsbecken, Einstellen der Zusammensetzung
412 Aktivkohlefilter, Filtern
414 Temperaturregelung
415 Pumpvorlage für Separieren von Fremdmetall
416 Verdunster, Aufkonzentrieren
419a,b Fluidkommunikation
420 Ionentauscher, Separieren von Fremdmetall
421 Beladen
422 Regenerieren, Strömen
425 Saure Lösung, Regeneriermedium
426 Regenerat, Fremdmetall-haltige saure Lösung, Regeneriermedium
430 Konzentrierte Fremdmetall-haltige saure Lösung
431 Bereitstellen an Leiterplatten Prozess
440 Membrandialyse, Separieren von Säure
441 Zulauf Dialyse
442 Membran
443 Zulauf Diffusat
445 Dialysat mit Metallsalz
446 Diffusat mit Säure (dritter Abtrennstrom)
447 Speicher-Modul Säure
450 Reaktionszelle, Elektrolysezelle
451 Elektrolyse (E-Modul)
452 Oxidation
455 Ablöse-Modul (L-Modul)
460 Luftzirkulation
461 Abluft
462 Zuluft
463 Luftfilter
464 Gesättigte Abluft
465 Natürliche Verdunstung
500 Weiterer Leiterplatten Prozess, Fotolack-Prozess
600 Prozesskontrollvorrichtung
610 Datenbank
611 Prozessparameter, Ist-Wert
620 Datenmodell-Einheit
621 Vorbestimmter Prozessparameter, Soll-Wert
622 Neuer vorbestimmter Prozessparameter
625 Selbstlernender Algorithmus
630 Berechnungsvorrichtung
631 Bestimmte Steueroperation
P Prozessrichtung

## Patentansprüche

1. Ein Verfahren (300) zum Aufbereiten eines aufzubereitenden Mediums (31) aus der Leiterplatten- und/oder Substrat-Herstellung, insbesondere einem Spülwasser und/oder Restwasser, wobei das aufzubereitende Medium (31) ein Metall aufweist, das Verfahren aufweisend:
Beladen (321) eines Ionentauschers (320) mit dem aufzubereitenden Medium (31) derart, dass das Metall zumindest teilweise an dem Ionentaucher (320) verbleibt; und
Regenerieren (322) des Ionentauschers (320) mittels Strömens eines Regeneriermediums (325, 326) durch den Ionentauscher (320) derart, dass das Metall zumindest teilweise in dem Regeneriermedium (325, 326) gelöst wird und ein Regenerat (326) bereitgestellt wird,
wobei das Regeneriermedium (325, 326) zumindest teilweise Verfahrens-intern erzeugt ist.

2. Das Verfahren (300) gemäß Anspruch 1,
wobei das Regeneriermedium (325, 326) eine hohe Säurekonzentration aufweist, insbesondere ≥ 200 g/L, weiter insbesondere ≥ 300 g/L, weiter insbesondere ≥ 400 g/L, weiter insbesondere ≥ 500 g/L.

3. Das Verfahren (300) gemäß Anspruch 1 oder 2, aufweisend zumindest eines der folgenden Merkmale:
wobei das Regeneriermedium (325, 326) Schwefelsäure, H₂SO₄, aufweist;
wobei das Metall zumindest ein Metall aus der Gruppe aufweist, welche besteht aus: Kupfer, Nickel, Cobalt, Palladium, Rhodium, Zinn, Cadmium, Magnesium, Natrium, Eisen, Silber, Gold;
wobei das Metall in Metallsalz vorliegt, insbesondere in Metallsulfat, weiter insbesondere Kupfersulfat, CuSO₄.

4. Das Verfahren (300) gemäß einem beliebigen der vorhergehenden Ansprüche, wobei das Regenerieren (322) ferner aufweist:
Bereitstellen des Regenerats (326), welches zumindest einen Teil des Metalls aus dem aufzubereitenden Medium (31) und zumindest einen Teil des Regeneriermediums (325, 326) aufweist, für ein Verfahren-internes Bereitstellen von Regeneriermedium (326), insbesondere wobei das Regenerieren (322) ferner aufweist:
Verwenden des Regenerats (326) zumindest teilweise als weiteres Regeneriermedium (325, 326) für zumindest einen weiteren Regenerierschritt (322) in dem Ionentauscher (320), weiter insbesondere
wobei das Regenerieren (322) ferner aufweist:
Durchführen von zumindest drei, insbesondere zumindest fünf, weiter insbesondere zumindest acht, weiteren Regenerierschritten (322) unter Verwenden des Regenerats (326),
insbesondere wobei die Konzentration des Metalls in dem Regenerat (326) mit jedem Regenerierschritt (322) ansteigt.

5. Das Verfahren (300) gemäß einem beliebigen der vorhergehenden Ansprüche, wobei das Regenerieren (322) ferner aufweist:
Zuführen von weiterer Säure (325), insbesondere Schwefelsäure, zu dem Regeneriermedium (325, 326), insbesondere dem Regenerat (326), insbesondere
wobei die weitere Säure (325) im Wesentlichen nicht Verfahren-intern erzeugt ist , weiter insbesondere
wobei die weitere Säure (325) im Wesentlichen aus der Leiterplatten- und/oder Substrat-Herstellung, insbesondere einem Prozess zum Rückgewinnen (400), stammt.

6. Das Verfahren (300) gemäß einem beliebigen der vorhergehenden Ansprüche, wobei das Verfahren aufweist:
Bereitstellen (305) des aufzubereitenden Mediums (31) mittels zumindest einem aus der Gruppe für die Leiterplatten- und/oder Substrat-Herstellung, welche besteht aus:
einem Spülwasser (32) und/oder einem Restwasser (352);
einem Diffusat (136) aus einem Verfahren (100) zum Aufbereiten von Rückständen aus einem Ätzprozess (150), bereitgestellt mittels eines ersten Abtrennstroms (5);
einem Diffusat (236) aus einem Verfahren (200) zum Aufbereiten von Rückständen aus einem Galvanikprozess (250), bereitgestellt mittels eines zweiten Abtrennstroms (6);
einem Diffusat (446) aus einem Verfahren zum Rückgewinnen (400) von aufbereiteten Rückständen, bereitgestellt mittels eines dritten Abtrennstroms (7).

7. Das Verfahren (300) gemäß einem beliebigen der vorhergehenden Ansprüche, wobei das Verfahren aufweist:
Vorbehandeln (310) des aufzubereitenden Mediums (31), insbesondere wobei das Vorbehandeln ferner zumindest eines der folgenden Merkmale aufweist:
Einstellen (311) des pH-Werts des aufzubereitenden Mediums (31), insbesondere mittels Natronlauge;
chemisches Reduzieren (312) des aufzubereitenden Mediums (31), insbesondere mittels Bisulfit;
Filtern von organischen Bestandteilen und/oder Rückständen aus dem aufzubereitenden Medium (31), insbesondere mittels eines Aktivkohlefilters (313).

8. Das Verfahren (300) gemäß einem beliebigen der vorhergehenden Ansprüche, wobei das Verfahren aufweist:
Separieren (327) eines Abwassers (350) aus dem Ionentauscher (320), wobei das Abwasser im Wesentlichen Schwermetall-frei ist, insbesondere wobei das Abwasser (350) in Einleitqualität vorliegt,
weiter insbesondere wobei die Konzentration an Schwermetall 15 mg/L oder weniger aufweist,
weiter insbesondere wobei die Konzentration an Kupfer 0,5 mg/Loder weniger aufweist und/oder wobei die Konzentration von Eisen 2 mg/L oder weniger aufweist.

9. Das Verfahren (300) gemäß einem beliebigen der vorhergehenden Ansprüche, wobei das Verfahren zumindest eines der folgenden Merkmale aufweist:
Bereitstellen (329) eines Metallsalz-haltigen Mediums (30) aus dem Regenerat (326);
Rückgewinnen (400) von elementarem Metall (50) aus dem Metallsalz-haltigen Medium (30) in einer Reaktionszelle (450), insbesondere mittels Elektrolyse (451);
wobei das Aufbereiten kontinuierlich betrieben wird.

10. Eine Vorrichtung (300) zum Aufbereiten eines aufzubereitenden Mediums (31) aus der Leiterplatten- und/oder Substrat-Herstellung, insbesondere einem Spülwasser und/oder Restwasser, wobei das aufzubereitende Medium (31) ein Metall aufweist, die Vorrichtung (300) aufweisend ein Ionentauscher-Modul (340) mit einem Ionentauscher (320) zum
Beladen (321) mit dem aufzubereitenden Medium (31) derart, dass das Metall an dem Ionentaucher (320) verbleibt, und
Regenerieren (322) des Ionentauschers (320) mittels Strömens eines Regeneriermediums (325, 326) durch den Ionentauscher (320) derart, dass das Metall zumindest teilweise in dem Regeneriermedium (325, 326) gelöst wird und ein Regenerat (326) bereitgestellt wird,
wobei das Regeneriermedium (325, 326) zumindest teilweise Vorrichtungs-intern erzeugt ist.

11. Die Vorrichtung (300) gemäß Anspruch 10, ferner aufweisend zumindest eines der folgenden Merkmale:
ein Speicher-Modul (328) zum
Speichern des Regenerats (326) aus dem Ionentauscher (320), wobei das Regenerat (326) zumindest einen Teil des Metalls aus dem aufzubereitenden Medium (31) und zumindest einen Teil des Regeneriermediums (325, 326) aufweist, und
Verwenden des Regenerats (326) zumindest teilweise als weiteres Regeneriermedium (325, 326) für ein oder mehr weitere Regenerierschritte (322) in dem Ionentauscher (320);
wobei der Ionentauscher (320) ein Oxidationsmittel-beständiges, insbesondere Wasserstoffperoxid-beständiges, Ionenaustauschharz aufweist.

12. Ein Verwenden eines Ionentauschers (320), um eine Mehrzahl von Abwässern (31, 32) aus der Leiterplatten- und/oder Substrat-Herstellung derart gemeinsam aufzubereiten, dass ein Schwermetall-freies Abwasser (350) bereitgestellt ist, welches Einleitqualität aufweist.

13. Eine Prozesskontrollvorrichtung (600) zum Regulieren eines Verfahrens gemäß einem beliebigen der Ansprüche 1 bis 9 und/oder einer Vorrichtung gemäß Anspruch 10 oder 11, wobei die Prozesskontrollvorrichtung (600) aufweist:
eine Datenbank (610) zum Erfassen von zumindest einem Prozessparameter (611) aus dem laufenden Prozess;
eine Datenmodell-Einheit (620), welche eingerichtet ist zum Speichern von zumindest einem vorbestimmten Prozessparameter (621); und
eine Berechnungsvorrichtung (630), welche eingerichtet ist zum Vergleichen des erfassten Prozessparameters (611) mit dem vorbestimmten Prozessparameter (621),
Bestimmen einer Steueroperation (631), welche auf dem Ergebnis des Vergleichens basiert, und
Durchführen der bestimmten Steueroperation (631).

14. Die Prozesskontrollvorrichtung (600) gemäß Anspruch 13, ferner aufweisend zumindest eines der folgenden Merkmale:
wobei die Berechnungsvorrichtung (630) einen selbstlernenden Algorithmus (625), insbesondere mittels neuronaler Netzwerke, zum Vergleichen und/oder zum Bestimmen aufweist;
wobei der selbstlernende Algorithmus (625) eingerichtet ist, die bestimmte Steueroperation (631) automatisch durchzuführen, und/oder wobei der selbstlernende Algorithmus (625) eingerichtet ist, die bestimmte Steueroperation (631) einem Benutzer zum Überprüfen bereitzustellen;
wobei der selbstlernende Algorithmus (625) eingerichtet ist basierend auf dem Vergleichen einen neuen vorbestimmten Prozessparameter (622) zu bestimmen und automatisch der Datenmodell-Einheit (620) zuzuführen, und/oder wobei der selbstlernende Algorithmus (625) eingerichtet ist basierend auf dem Vergleichen einen neuen vorbestimmten Prozessparameter (622) zu bestimmen und dem Benutzer zum Überprüfen bereitzustellen;
wobei der selbstlernende Algorithmus (625) eingerichtet ist, das Ergebnis des Überprüfens durch den Benutzer als Lerngrundlage zu verwenden.

15. Ein Computerprogramm-Produkt zum Steuern eines Verfahrens (300) zum Aufbereiten eines aufzubereitenden Mediums (31) aus der Leiterplattenund/oder Substrat-Herstellung, welches Computerprogramm-Produkt, wenn es von einem oder mehreren Prozessoren ausgeführt wird, das Verfahren nach einem beliebigen der Ansprüche 1 bis 9 und/oder die Vorrichtung nach Anspruch 10 oder 11 und/oder die Prozesskontrollvorrichtung (600) nach Anspruch 13 oder 14 steuert.
